# EUROPÄISCHE PATENTSCHRIFT

(11) **EP 4 133 915 B1**
(45) Veröffentlichungstag und Bekanntmachung des Hinweises auf die Patenterteilung: **17.09.2025**
(21) Anmeldenummer: 21716347.6
(22) Anmeldetag: 30.03.2021
(51) Int. Cl.: H05K 5/06

(54) **GEHÄUSEDECKEL**
HOUSING COVER
COUVERCLE

(30) Priorität: 08.04.2020 DE 102020109893
(43) Veröffentlichungstag der Anmeldung: 15.02.2023
(73) Patentinhaber: ElringKlinger AG, 72581 Dettingen (DE)
(72) Erfinder: SCHÖLLHAMMER, Jochen, 72581 Dettingen (DE); EBERLE, Bernhard, 72555 Metzingen (DE); KUNERT, Tobias, 72764 Reutlingen (DE)
(74) Vertreter: Hoeger, Stellrecht & Partner Patentanwälte mbB
(86) Internationale Anmeldenummer: PCT/EP2021/058343
(87) Internationale Veröffentlichungsnummer: WO 2021/204605

(56) Entgegenhaltungen:
- EP-B1- 1 569 505
- EP-B1- 1 874 103
- JP-A- 2004 095 929
- JP-A- 2004 146 284
- JP-A- 2008 117 973
- JP-A- 2008 218 946
- JP-A- 2009 026 978
- JP-A- 2011 071 362
- JP-A- 2015 141 991
- JP-A- H0 942 777
- JP-A- H04 259 286
- JP-A- H08 298 384
- JP-A- H11 233 962
- JP-U- S5 456 754
- US-A1- 2001 040 037
- US-A1- 2011 088 241
- US-A1- 2012 320 544
- US-A1- 2017 013 737

## Beschreibung

Die vorliegende Erfindung betrifft einen Gehäusedeckel zum Festlegen an einem Gehäuse, wobei der Gehäusedeckel mit mehreren Befestigungsmittel-Durchtrittsöffnungen und mit einem Dichtungswulst, der ein elastomeres Material umfasst, versehen ist und wobei der Dichtungswulst an einer Dichtungstragefläche des Gehäusedeckels angeordnet ist.

Aus der EP 1 683 997 A2 ist ein Gehäusedeckel bekannt, bei welchem ein Dichtungswulst aus einem Elastomermaterial in einer in den Gehäusedeckel eingeprägten Nut angeordnet ist.

Durch das Erfordernis, in dem Gehäusedeckel eine Nut vorzusehen, deren Breite im unverpressten Zustand des Gehäusedeckels größer sein muss als die Breite des Dichtungswulstes, wird die Gestaltungsfreiheit beim Design des Gehäusedeckels eingeschränkt.

Die JP 2015 141991 A offenbart einen Gehäusedeckel zum Festlegen an einem Gehäuse gemäß dem Oberbegriff von Anspruch 1.

Die JP H11 233962 A offenbart einen Gehäusedeckel zum Festlegen an einem Gehäuse, wobei der Gehäusedeckel einen abgebogenen Randbereich umfasst, welcher beim Verspannen des Gehäusedeckels und des Gehäuses gegen ein Dichtelement gedrückt wird.

Die JP 2004 095929 A offenbart einen Gehäusedeckel zum Festlegen an einem Gehäuse, wobei an dem Gehäuse eine Nut vorgesehen ist, in welcher eine Dichtung aufgenommen ist, wobei der Gehäusedeckel die Nut überdeckt.

Die JP 2011 071362 A offenbart einen Gehäusedeckel zum Festlegen an einem Gehäuse, wobei das Gehäuse mindestens eine Nut umfasst, in welcher eine Dichtung angeordnet ist, wobei der Gehäusedeckel die mindestens eine Nut überdeckt.

Der vorliegenden Erfindung liegt die Aufgabe zugrunde, einen Gehäusedeckel der eingangs genannten Art zu schaffen, bei welchem der Verlauf des Dichtungswulstes freier gestaltbar und insbesondere näher an die Befestigungsmittel-Durchtrittsöffnungen des Gehäusedeckels heran legbar ist und welcher insbesondere auch aus einem relativ dünnen Ausgangsmaterial herstellbar ist.

Diese Aufgabe wird durch einen Gehäusedeckel nach Anspruch 1 gelöst.

Bei dem erfindungsgemäßen Gehäusedeckel liegt im montierten Zustand des Gehäusedeckels, in welchem der Dichtungswulst zwischen dem Gehäusedeckel und dem mittels des Gehäusedeckels zu verschließenden Gehäuse verpresst wird, das Verformungsbegrenzungselement im Kraft-Hauptschluss und der Dichtungswulst im Kraft-Nebenschluss. Hierdurch wird eine übermäßige Verformung des Dichtungswulstes vermieden.

Grundsätzlich könnte das mindestens eine Verformungsbegrenzungselement beispielsweise durch einen Prägevorgang oder einen Tiefziehvorgang an einem Grundkörper des Gehäusedeckels erzeugt sein.

Die Erzeugung eines Verformungsbegrenzungselements, das typischerweise eine Höhe von beispielsweise 1,0 mm aufweist, an einem blechförmigen Ausgangsmaterial, das eine geringe Materialstärke von beispielsweise 1,5 mm oder weniger aufweist, ist aufgrund der Materialschwächung in diesem Bereich durch den Prägevorgang problematisch.

Es ist daher von Vorteil, dass gemäß der vorliegenden Erfindung statt eines Prägevorgangs oder eines Tiefziehvorgangs ein Biegevorgang zur Erzeugung des Verformungsbegrenzungselements benutzt wird.

Durch die Erzeugung des mindestens einen Verformungsbegrenzungselements durch einen Biegevorgang ist es ohne weiteres möglich, ein Verformungsbegrenzungselement, das um eine Höhe H von ungefähr 1,0 mm über die Dichtungstragefläche übersteht, an einem Ausgangsmaterial mit einer Materialstärke von 1,5 mm oder weniger zu erzeugen, ohne das Material des Gehäusedeckels in dem Biegebereich zu schwächen.

Bei einer besonderen Ausgestaltung der Erfindung ist vorgesehen, dass der Biegewinkel α im Biegebereich im Wesentlichen 90° beträgt.

In diesem Fall wird also ein dem Dichtungstragebereich abgewandter Endbereich des Biegebereichs im Wesentlichen senkrecht zur Dichtungstragefläche in die im montierten Zustand des Gehäusedeckels zu dem Gehäuse weisende Richtung gestellt, ohne einen Bereich des Gehäusedeckels auf einen anderen Bereich des Gehäusedeckels umzulegen.

Hierdurch kann das Verformungsbegrenzungselement sehr platzsparend ausgebildet sein.

Diese Ausführungsform des Verformungsbegrenzungselements eignet sich insbesondere zur Erzeugung eines Verformungsbegrenzungselements in einem zwischen zwei Befestigungsmittel-Durchtrittsöffnungen des Gehäusedeckels angeordneten Zwischen-Befestigungsmittel-Durchtrittsöffnungs-Bereich des Gehäusedeckels.

Der Biegebereich endet vorzugsweise an einer Stirnfläche, mit welcher der Gehäusedeckel an das Gehäuse anlegbar ist.

Bei einer anderen Ausgestaltung der Erfindung ist vorgesehen, dass der Biegewinkel α mehr als 160°, besonders bevorzugt ungefähr 180°, beträgt.

Dabei umfasst das Verformungsbegrenzungselement vorzugsweise einen Umlagebereich, welcher, vorzugsweise einstückig, über den Biegebereich und einen Anlagebereich mit einem Dichtungstragebereich des Gehäusedeckels, an welchem der Dichtungswulst angeordnet ist, verbunden ist, wobei der Umlagebereich an dem Anlagebereich auf derselben Seite des Gehäusedeckels anliegt, auf welcher der Dichtungswulst an dem Dichtungstragebereich angeordnet ist.

Der Umlagebereich liegt vorzugsweise flächig, besonders bevorzugt vollflächig oder im Wesentlichen vollflächig, an dem Anlagebereich des Gehäusedeckels an.

Die mittlere Dicke des Umlagebereichs kann im Wesentlichen gleich groß sein wie die mittlere Dicke des Anlagebereichs.

Dabei kann die Dicke des Umlagebereichs und die Dicke des Anlagebereichs der Dicke des Ausgangsmaterials entsprechen, aus welchem der Gehäusedeckel gebildet wird.

Dieses Ausgangsmaterial ist vorzugsweise ein blechförmiges Material.

Ferner ist das Ausgangsmaterial vorzugsweise ein metallisches Material.

Beispielsweise kann das Ausgangsmaterial Aluminium umfassen, insbesondere als Hauptbestandteil.

Das Ausgangsmaterial kann eine Aluminiumlegierung sein.

Ferner kann vorgesehen sein, dass das Ausgangsmaterial ein Stahlmaterial, vorzugsweise ein Edelstahlmaterial, ist.

Bei einer besonderen Ausgestaltung der Erfindung ist vorgesehen, dass die mittlere Dicke des Umlagebereichs kleiner ist als die mittlere Dicke des Anlagebereichs.

Die Dicke des Umlagebereichs kann dabei beispielsweise durch einen Planiervorgang gegenüber der Dicke des Anlagebereichs reduziert werden. Dabei wird vorzugsweise in dem Anlagebereich kein Planiervorgang durchgeführt oder ein Planiervorgang, der einen geringeren Umformgrad aufweist als der Planiervorgang, der an dem Umlagebereich durchgeführt wird.

Die Dicke des Anlagebereichs kann in diesem Fall gleich groß sein wie die Dicke des Dichtungstragebereichs oder aber kleiner sein als die Dicke des Dichtungstragebereichs.

Bei einer besonderen Ausgestaltung der Erfindung ist vorgesehen, dass die Dicke des Umlagebereichs mit wachsendem Abstand von dem Biegebereich variiert.

Insbesondere kann vorgesehen sein, dass die Dicke des Umlagebereichs mit wachsendem Abstand von dem Biegebereich abnimmt.

Die Dicke des Umlagebereichs kann in Abhängigkeit vom Abstand von dem Biegebereich kontinuierlich, vorzugsweise linear, variieren.

Ferner ist bei einer besonderen Ausgestaltung der Erfindung vorgesehen, dass die Dicke des Anlagebereichs mit wachsendem Abstand von dem Biegebereich variiert.

Vorzugsweise ist vorgesehen, dass die Dicke des Anlagebereichs mit wachsendem Abstand von dem Biegebereich zunimmt.

Die Dicke des Anlagebereichs kann in Abhängigkeit von dem Abstand von dem Biegebereich kontinuierlich, vorzugsweise linear, variieren.

Bei einer besonders bevorzugten Ausgestaltung der Erfindung ist vorgesehen, dass die Summe D_{G} aus der lokalen Dicke D_{U} des Umlagebereichs und der lokalen Dicke D_{A} des Anlagebereichs im Wesentlichen unabhängig vom Abstand von dem Biegebereich und somit vorzugsweise im Wesentlichen konstant ist.

Bei einer sehr einfach herzustellenden Ausführungsform des erfindungsgemäßen Gehäusedeckels ist vorgesehen, dass die Dicke des Umlagebereichs und die Dicke des Anlagebereichs im Wesentlichen gleich groß ist wie die Dicke des Dichtungstragebereichs und vorzugsweise im Wesentlichen gleich groß ist wie die Dicke des Ausgangsmaterials, aus welchem der Gehäusedeckel hergestellt wird.

In diesem Fall kann der Biegevorgang zur Herstellung des Biegebereichs ausgeführt werden, ohne dass zuvor ein Planiervorgang zur Reduzierung einer Dicke des Anlagebereichs und/oder zur Reduzierung einer Dicke des Umlagebereichs durchgeführt wird.

Allerdings ist bei einer solchen Ausführungsform des Gehäusedeckels die Höhe H des Verformungsbegrenzungselements über der Dichtungstragefläche durch die Dicke des Ausgangsmaterials vorgegeben.

Bei einer besonderen Ausgestaltung des Gehäusedeckels ist daher vorgesehen, dass die Dicke des Umlagebereichs und/oder die Dicke des Anlagebereichs zumindest abschnittsweise kleiner ist als die Dicke des Dichtungstragebereichs.

Hierdurch ist es möglich, das Verformungsbegrenzungselement so auszubilden, dass die Dicke H des Verformungsbegrenzungselements über der Dichtungstragefläche kleiner ist als die Dicke des Ausgangsmaterials.

Bei einer ersten Alternative der Erfindung umfasst das mindestens eine Verformungsbegrenzungselement mindestens einen Befestigungsmittel-Durchtrittsöffnungs-Abschnitt, der sich längs einer Umfangsrichtung einer der Befestigungsmittel-Durchtrittsöffnungen über einen Umfangswinkel β um die betreffende Befestigungsmittel-Durchtrittsöffnung erstreckt.

Vorzugsweise ist dieser Umfangswinkel kleiner als 360°.

Der Umfangswinkel β, der in Bezug auf die Längsmittelachse der jeweiligen Befestigungsmittel-Durchtrittsöffnung bestimmt wird, beträgt vorzugsweise mehr als 90°, insbesondere mehr als 120°, besonders bevorzugt mehr als 160°.

Ferner beträgt der Umfangswinkel β, der in Bezug auf die Längsmittelachse der jeweiligen Befestigungsmittel-Durchtrittsöffnung bestimmt wird, vorzugsweise weniger als 270°, besonders bevorzugt weniger als 200°.

Bei einer zweiten Alternative der Erfindung umfasst das mindestens eine Verformungsbegrenzungselement mindestens einen Zwischen-Befestigungsmittel-Durchtrittsöffnungs-Abschnitt, der sich längs einer Umfangsrichtung eines zwischen zwei der Befestigungsmittel-Durchtrittsöffnungen liegenden Randabschnitts des Gehäusedeckels erstreckt.

Der zwischen zwei der Befestigungsmittel-Durchtrittsöffnungen liegende Randabschnitt des Gehäusedeckels kann im Wesentlichen geradlinig oder gekrümmt ausgebildet sein.

Der Zwischen-Befestigungsmittel-Durchtrittsöffnungs-Abschnitt des Verformungsbegrenzungselements erstreckt sich vorzugsweise über mehr als die Hälfte der Länge des zwischen den beiden Befestigungsmittel-Durchtrittsöffnungen liegenden Randabschnitts des Gehäusedeckels, insbesondere über mehr als drei Viertel der Länge dieses Randabschnitts, besonders bevorzugt über mehr als 90 % der Länge dieses Randabschnitts.

Der Zwischen-Befestigungsmittel-Durchtrittsöffnungs-Abschnitt des Verformungsbegrenzungselements kann mindestens eine Ablauföffnung aufweisen und/oder an mindestens einer Ablauföffnung enden.

Eine solche Ablauföffnung stellt eine Fluidverbindung von dem Zwischenbereich zwischen dem Dichtungswulst und dem Zwischen-Befestigungsmittel-Durchtrittsöffnungs-Abschnitt des Verformungsbegrenzungselements zu dem Außenraum des Gehäusedeckels her, so dass Feuchtigkeit oder Flüssigkeit, welche in diesen Zwischenbereich des Gehäusedeckels gelangt oder dort entsteht, durch die mindestens eine Ablauföffnung in den Außenraum des Gehäusedeckels ablaufen kann und somit eine Korrosion durch eine solche Ansammlung von Feuchtigkeit oder Flüssigkeit in dem Zwischenbereich des Gehäusedeckels verhindert wird.

Der Zwischen-Befestigungsmittel-Durchtrittsöffnungs-Abschnitt des Verformungsbegrenzungselements kann insbesondere an einem seiner Endbereiche oder an beiden Endbereichen an jeweils eine Ablauföffnung angrenzen, welche dem Zwischen-Befestigungsmittel-Durchtrittsöffnungs-Abschnitt gegenüberliegend von einem Befestigungsmittel-Durchtrittsöffnungs-Abschnitt des Verformungsbegrenzungselements begrenzt wird.

Insbesondere kann eine solche Ablauföffnung also die Form eines Spalts oder einer Lücke zwischen einem Zwischen-Befestigungsmittel-Durchtrittsöffnungs-Abschnitt des Verformungsbegrenzungselements und einem Befestigungsmittel-Durchtrittsöffnungs-Abschnitt des Verformungsbegrenzungselements aufweisen.

Der mindestens eine Befestigungsmittel-Durchtrittsöffnungs-Abschnitt und/oder der mindestens eine Zwischen-Befestigungsmittel-Durchtrittsöffnungs-Abschnitt des Verformungsbegrenzungselements umfasst mehrere Segmente, zwischen denen in einem Ausgangszustand des Gehäusedeckels vor dem Erzeugen des Biegebereichs mindestens eine Lücke angeordnet ist.

Im betriebsfertigen Zustand des Gehäusedeckels, nach dem Erzeugen des Biegebereichs, kann die mindestens eine Lücke zwischen den mehreren Segmenten des Verformungsbegrenzungselements, insbesondere des Umlagebereichs des Verformungsbegrenzungselements, geschlossen sein.

Ferner kann vorgesehen sein, dass im betriebsbereiten Zustand des Gehäusedeckels jeweils mindestens zwei der Segmente des Verformungsbegrenzungselements miteinander verpresst sind.

Durch eine solche Verpressung kann insbesondere ein Zusammenfließen des Materials von jeweils mindestens zwei der Segmente des Verformungsbegrenzungselements miteinander bewirkt werden.

Der aus den Segmenten des Verformungsbegrenzungselements gebildete Umlagebereich des Verformungsbegrenzungselements kann im betriebsbereiten Zustand des Gehäusedeckels einteilig ausgebildet sein.

Das Gehäuse, an welchem der erfindungsgemäße Gehäusedeckel festlegbar ist, kann insbesondere ein Gehäuse einer elektrischen Vorrichtung, beispielsweise einer elektrischen Steuervorrichtung, ein Gehäuse eines Wechselrichters oder ein Gehäuse einer elektrischen Antriebseinheit, beispielsweise eines Elektrofahrzeugs, sein.

Der erfindungsgemäße Gehäusedeckel eignet sich zur Verwendung als Bestandteil einer Baugruppe, welche das Gehäuse und den erfindungsgemäßen Gehäusedeckel umfasst.

Durch eine Unterteilung des Umlagebereichs des Verformungsbegrenzungselements in mehrere Segmente ist es möglich, ein Verformungsbegrenzungselement mit einem solchen Umlagebereich an einem geradlinigen Randabschnitt des Gehäusedeckels oder auch an einem gekrümmten Randabschnitt des Gehäusedeckels auszubilden.

Eine Bauteilschwächung des Gehäusedeckels wird vermieden, da die Segmente des Umlagebereichs außerhalb der Bauteilkontur des Gehäusedeckels liegen und auf einen innerhalb der Bauteilkontur liegenden Anlagebereich des Gehäusedeckels umgelegt werden.

Hierdurch können sehr platzsparende und flexibel anwendbare Verformungsbegrenzungselemente an einem Gehäusedeckel erzeugt werden, dessen Ausgangsmaterial eine Materialstärke von 1,5 mm oder weniger aufweist, ohne das Material des Gehäusedeckels durch Einprägungen zu schwächen.

Das Verformungsbegrenzungselement, auch als Stopper bezeichnet, dient dazu, den Dichtungswulst, beispielsweise eine CIP("Cured in Place")-Dichtraupe, auf ein definiertes Maß zu verpressen und ein Überpressen der Dichtung zu verhindern.

In der Außenkontur des Gehäusedeckels können Laschen vorgesehen sein, welche partiell um jeweils eine zugeordnete Befestigungsmittel-Durchtrittsöffnung, beispielsweise ein Schraubenauge, gelegt werden.

Die Auflagefläche, an der das Befestigungsmittel, beispielsweise eine Befestigungsschraube, im montierten Zustand des Gehäusedeckels anliegt, befindet sich auf der im Wesentlichen ebenen, nicht umgelegten Seite des Gehäusedeckels, so dass ein vollflächiger Kontakt zwischen dem Befestigungsmittel, insbesondere dem Kopf einer Befestigungsschraube, und dem Gehäusedeckel gewährleistet ist.

Die Dicke des Anlagebereichs, des Biegebereichs und/oder des Umlagebereichs kann vor oder nach dem Biegevorgang durch einen Umformvorgang, vorzugsweise durch einen Planiervorgang, gegenüber der Ausgangs-Materialstärke des Ausgangsmaterials, aus welchem der Gehäusedeckel hergestellt wird, reduziert werden.

Der Planiervorgang wird an dem Ausgangsmaterial vorzugsweise von der Blattinnenseite in Richtung auf die Blattaußenseite durchgeführt, so dass keine Höhendifferenz oder Kante während des Umlegens des Umlagebereichs auf den Anlagebereich zu überwinden ist.

Durch die Verringerung der Dicke des Anlagebereichs und/oder des Umlagebereichs gegenüber der Materialstärke des Ausgangsmaterials kann erreicht werden, dass die Höhe H, um welche das Verformungsbegrenzungselement über die Dichtungstragefläche, an welcher der Dichtungswulst angeordnet ist, übersteht, kleiner ist als die Materialstärke oder Dicke des Ausgangsmaterials.

Dies wird erreicht, ohne in die Werkstoffstruktur des Gehäusedeckels einzugreifen, da der Umlagebereich von außen nach innen gestellt wird.

Die Dicke des Umlagebereichs und/oder des Anlagebereichs wird vorzugsweise um mindestens 10 %, insbesondere um mindestens 20 %, besonders bevorzugt um mindestens 30 %, relativ zur Dicke des Ausgangsmaterials reduziert.

Der Grad, in dem die Dicke des Ausgangsmaterials im Bereich des Anlagebereichs und/oder im Bereich des Umlagebereichs reduziert wird, kann innerhalb des Anlagebereichs, innerhalb des Umlagebereichs und/oder zwischen dem Anlagebereich und dem Umlagebereich variieren.

Eine im Wesentlichen lineare Variation des Umformgrades kann beispielsweise durch Verwendung eines keilförmigen Planierwerkzeugs erreicht werden.

Insbesondere kann vorgesehen sein, dass die mittlere Dicke des Umformbereichs kleiner ist als die mittlere Dicke des Anlagebereichs. Hierdurch wird die Materialverdrängung im Anlagebereich auf ein Minimum begrenzt und der hohe Umformgrad auf den Umlagebereich verschoben. Dies bietet den Vorteil, dass überschüssiges Material nur in geringem Maß in Richtung auf den Dichtungswulst und/oder in Richtung auf die Befestigungsmittel-Durchtrittsöffnung gedrückt wird.

Die gewünschte Kontur des Umlagebereichs wird trotz der hohen Materialverdrängung im Umlagebereich dadurch gewährleistet, dass der Umlagebereich erst nach dem Umformvorgang zum Reduzieren der Dicke des Umlagebereichs, beispielsweise nach einem Planiervorgang, aus dem Ausgangsmaterial herausgetrennt, insbesondere ausgeschnitten oder ausgestanzt, wird.

Ist der Umlagebereich vor dem Biegevorgang, durch welchen der Umlagebereich auf den Anlagebereich umgelegt wird, einteilig ausgebildet, so wird das so hergestellte Verformungsbegrenzungselement als ein "Umlagestopper" bezeichnet.

Ist der Umlagebereich zumindest vor dem Biegevorgang in mehrere einzelne Segmente unterteilt, so wird das so hergestellte Verformungsbegrenzungselement als ein "Segmentstopper" bezeichnet.

Ein Verformungsbegrenzungselement mit einem in Segmente unterteilten Umlagebereich ist vorzugsweise an einem gekrümmten Abschnitt der Außenkontur des Gehäusedeckels vorgesehen.

Es kann vorgesehen sein, dass die Segmente nach dem Umlegen auf den Anlagebereich so verpresst werden, dass das Material der Segmente zusammenfließt und sich ein flächiger Umlagebereich des betriebsfertigen Gehäusedeckels bildet.

Die Segmente eines Umlagebereichs können ebenso wie ein einteiliger Umlagebereich hinsichtlich ihrer Dicke reduziert werden, insbesondere durch Planieren, um eine gewünschte Höhe H des Verformungsbegrenzungselements über der Dichtungstragefläche einzustellen.

Ein einteiliger Umlagebereich oder ein in Segmente unterteilter Umlagebereich kann auch nach dem Biegevorgang, durch welchen der Umlagebereich auf den Anlagebereich umgelegt wird, in seiner Dicke reduziert werden, beispielsweise durch einen Planiervorgang.

Ein Verformungsbegrenzungselement kann auch im Schraubenzwischenbereich vorgesehen sein, das heißt in einem Zwischen-Befestigungsmittel-Durchtrittsöffnungs-Bereich des Gehäusedeckels.

In diesem Bereich kann das Verformungsbegrenzungselement zum Schutz des Dichtungswulstes gegen äußere Einflüsse dienen, beispielsweise zum Schutz vor dem Eindringen von Verunreinigungen, aggressiven Medien und/oder unter hohem Druck stehenden Medien in den Bereich des Dichtungswulstes.

Außerdem kann das Verformungsbegrenzungselement einen elektrisch leitenden, insbesondere metallisch leitenden, Kontakt zwischen dem Gehäusedeckel und dem Gehäuse herstellen und dadurch die Funktion eines EMV(elektromagnetische Verträglichkeit)-Schutzes erfüllen.

Auch bei der Anordnung im Zwischen-Befestigungsmittel-Durchtrittsöffnungs-Bereich des Gehäusedeckels können der Anlagebereich und/oder der Umlagebereich des Verformungsbegrenzungselements dickenprofiliert werden, beispielsweise durch einen Planiervorgang.

Ferner kann auch bei der Anordnung des Verformungsbegrenzungselements im Zwischen-Befestigungsmittel-Durchtrittsöffnungs-Bereich der Umlagebereich des Verformungsbegrenzungselements in mehrere Segmente unterteilt sein.

Ferner ist es günstig, wenn die Höhe H des Verformungsbegrenzungselements über der Dichtungstragefläche mit wachsendem Abstand von der nächstgelegenen Befestigungsmittel-Durchtrittsöffnung zunimmt. Durch die so gestaltete Topographie des Verformungsbegrenzungselements wird die Variation der Flächenpressung, mit welcher der Gehäusedeckel mittels der durch die Befestigungsmittel-Durchtrittsöffnungen hindurchtretenden Befestigungsmittel, insbesondere Befestigungsschrauben, verspannt wird, in der Längsrichtung des Dichtungswulstes, welche aufgrund der variierenden Abstände von dem jeweils nächstliegenden Befestigungsmittel hervorgerufen wird, zumindest teilweise ausgeglichen und somit ein gleichmäßiges Anliegen des Dichtungswulstes an dem zu verschließenden Gehäuse an jeder Stelle des Dichtungswulstes erzielt.

Diese Topographie des Verformungsbegrenzungselements kann vor und/oder nach dem Biegevorgang erzeugt werden.

Wenn das Verformungsbegrenzungselement keinen Umlagebereich umfasst, sondern der Biegewinkel des Biegebereichs nur ungefähr 90° beträgt, so dass der Biegebereich im montierten Zustand des Gehäusedeckels mit einer Stirnfläche an dem Gehäuse anliegt, so bietet dies den Vorteil eines besonders platzsparenden Aufbaus des Verformungsbegrenzungselements.

Ein solches Verformungsbegrenzungselement kann sowohl in einem Befestigungsmittel-Durchtrittsöffnungs-Bereich des Gehäusedeckels als auch in einem Zwischen-Befestigungsmittel-Durchtrittsöffnungs-Bereich des Gehäusedeckels angeordnet sein.

Ein solches Verformungsbegrenzungselement bietet einen mechanischen Schutz für den Dichtungswulst vor Verunreinigungen, vor aggressiven Medien und/oder vor unter hohem Druck stehenden Medien (beispielsweise vor einem Hochdruck-Wasserstrahl), die sonst aus dem Außenraum des Gehäuses bis zu dem Dichtungswulst gelangen könnten.

Außerdem bietet ein solches Verformungsbegrenzungselement durch den guten elektrisch leitfähigen Kontakt zwischen dem Gehäusedeckel und dem Gehäuse im montierten Zustand des Gehäusedeckels eine EMV-Optimierung.

Ein Verformungsbegrenzungselement, dessen Biegebereich einen Biegewinkel von ungefähr 90° aufweist, weist keine Materialschwächung durch einen Prägevorgang oder einen Kröpfvorgang auf.

Ferner ist bei einem solchen Verformungsbegrenzungselement kein Planiervorgang erforderlich, um eine gewünschte Höhe H des Verformungsbegrenzungselements über der Dichtungstragefläche einzustellen.

Ein Verformungsbegrenzungselement mit einem Biegebereich, der einen Biegewinkel von ungefähr 90° aufweist, eignet sich insbesondere dann, wenn der Gehäusedeckel aus einem Ausgangsmaterial mit einer Materialstärke von 2,0 mm oder weniger hergestellt wird.

Die Verwendung eines Verformungsbegrenzungselements mit einem Biegebereich, dessen Biegewinkel ungefähr 180° beträgt und das einen Umlagebereich umfasst, der an einem Anlagebereich des Gehäusedeckels, vorzugsweise flächig, anliegt, eignet sich insbesondere dann, wenn der Gehäusedeckel aus einem Ausgangsmaterial mit einer Materialstärke von 1,0 mm bis 1,5 mm hergestellt wird.

Weitere Merkmale und Vorteile der Erfindung sind Gegenstand der nachfolgenden Beschreibung und der zeichnerischen Darstellung von Ausführungsbeispielen.

In den Zeichnungen zeigen:

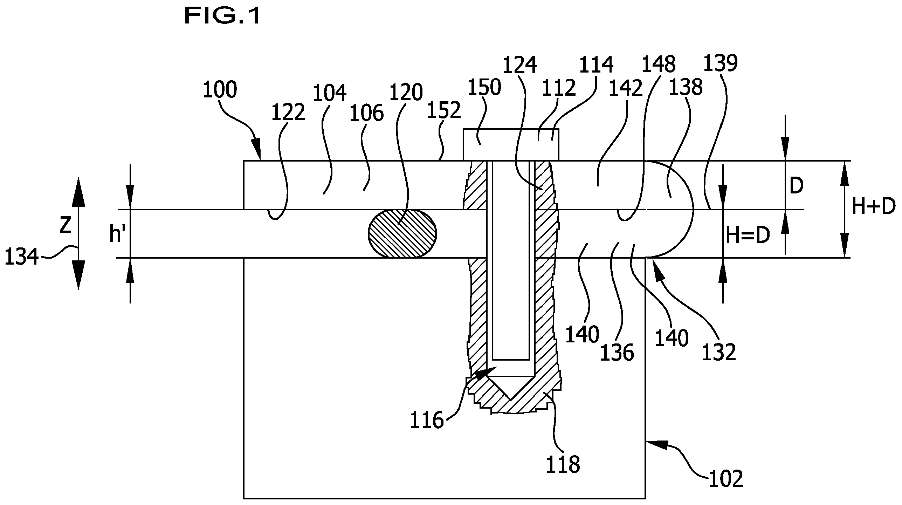

- Fig. 1: eine teilweise geschnittene Seitenansicht eines Randbereichs einer nicht erfindungsgemäßen ersten Ausführungsform eines Gehäusedeckels, der mittels eines Befestigungsmittels, das sich durch eine Befestigungsmittel-Durchtrittsöffnung des Gehäusedeckels hindurch erstreckt, an einem Gehäuse festgelegt ist, wobei ein Dichtungswulst, der ein elastomeres Material umfasst, an einer Dichtungstragefläche des Gehäusedeckels angeordnet ist und der Gehäusedeckel ein Verformungsbegrenzungselement umfasst, welches über die Dichtungstragefläche in derselben Richtung vorsteht wie der Dichtungswulst und eine Verformung des Dichtungswulstes im montierten Zustand des Gehäusedeckels begrenzt, wobei das Verformungsbegrenzungselement einen Biegebereich umfasst, in welchem das Material des Verformungsbegrenzungselements um einen Biegewinkel von ungefähr 180° aus einer im Wesentlichen parallel zu der Dichtungstragefläche verlaufenden Bezugsebene herausgebogen ist, und einen Umlagebereich, welcher über den Biegebereich und einen Anlagebereich mit einem Dichtungstragebereich des Gehäusedeckels, an welchem der Dichtungswulst angeordnet ist, verbunden ist und an dem Anlagebereich auf derselben Seite des Gehäusedeckels anliegt, auf welcher der Dichtungswulst an dem Dichtungstragebereich angeordnet ist;

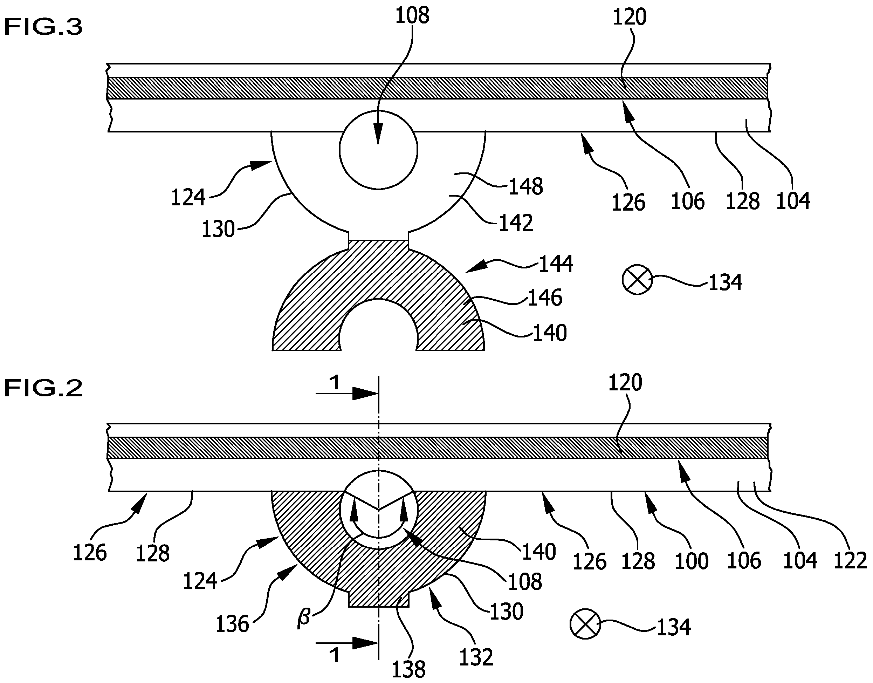

- Fig. 2: eine Draufsicht auf den Randbereich des Gehäusedeckels aus Fig. 1, mit der Blickrichtung auf die im montierten Zustand des Gehäusedeckels dem Gehäuse zugewandte Dichtungstragefläche des Gehäusedeckels;
- Fig. 3: eine Draufsicht auf den Randbereich einer Gehäusedeckel-Vorform, aus welcher der Gehäusedeckel gemäß den Fig. 1 und 2 durch einen Biegevorgang erzeugt wird;

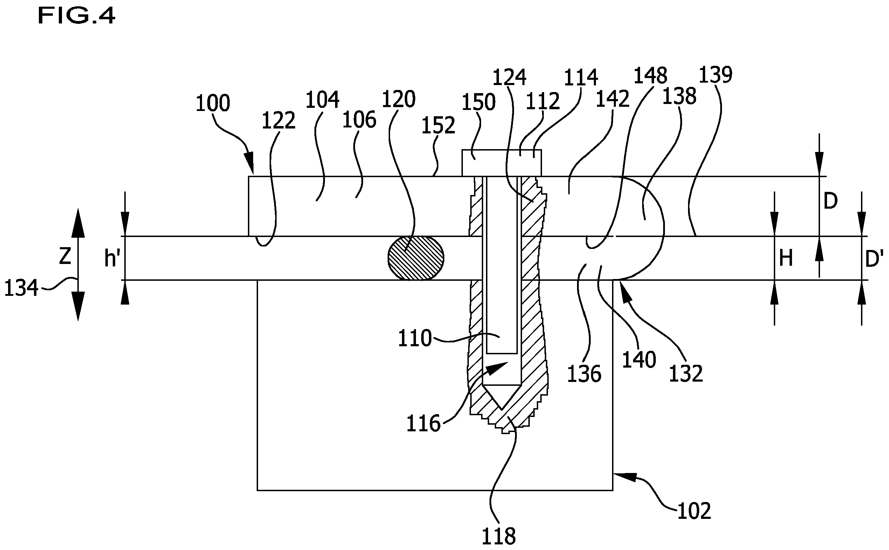

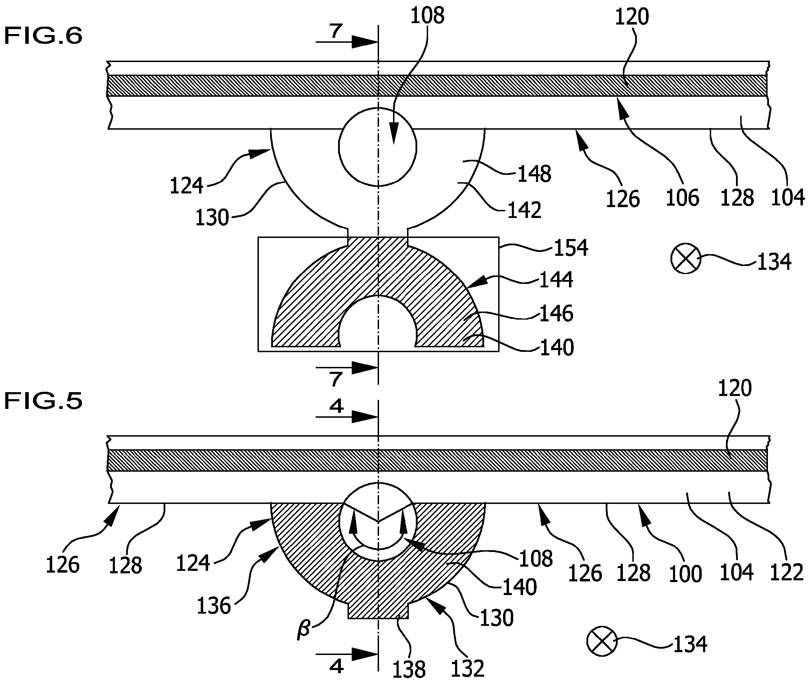

- Fig. 4: einen der Fig. 1 entsprechenden Schnitt, längs der Linie 4 - 4 in Fig. 5, durch einen Randbereich einer nicht erfindungsgemäßen zweiten Ausführungsform eines Gehäusedeckels, bei welcher die Dicke des Umlagebereichs kleiner ist als die Dicke des Anlagebereichs und kleiner ist als die Dicke des Dichtungstragebereichs;
- Fig. 6: eine Draufsicht auf den Randbereich einer Gehäusedeckel-Vorform der zweiten Ausführungsform eines Gehäusedeckels, mit der Blickrichtung auf die Dichtungstragefläche des Gehäusedeckels;

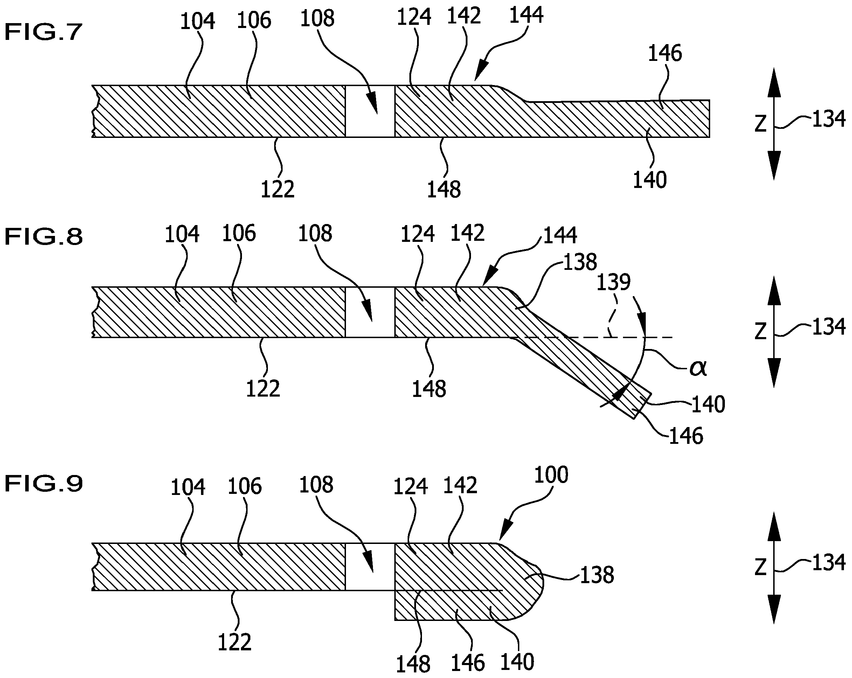

- Fig. 7: einen Schnitt durch den Randbereich der Gehäusedeckel-Vorform aus Fig. 6, längs der Linie 7 - 7 in Fig. 6, ohne den Dichtungswulst, wobei die Dicke des Umlagebereichs durch einen Planiervorgang gegenüber der Dicke des Anlagebereichs und der Dicke des Dichtungstragebereichs reduziert worden ist;
- Fig. 8: einen der Fig. 7 entsprechenden Schnitt durch den Randbereich der Gehäusedeckel-Vorform, nachdem mit der Erzeugung des Biegebereichs begonnen worden ist und Material des Verformungsbegrenzungselements um einen spitzen Winkel α aus der parallel zu der Dichtungstragefläche verlaufenden Bezugsebene des Gehäusedeckels herausgebogen worden ist;
- Fig. 9: einen den Fig. 7 und 8 entsprechenden Schnitt durch den Randbereich des Gehäusedeckels, nachdem der Biegevorgang zur Erzeugung des Biegebereichs abgeschlossen ist, Material des Verformungsbegrenzungselements um einen Biegewinkel von 180° aus einer parallel zu der Dichtungstragefläche verlaufenden Bezugsebene herausgebogen worden ist und der Umlagebereich flächig an dem Anlagebereich des Gehäusedeckels anliegt;

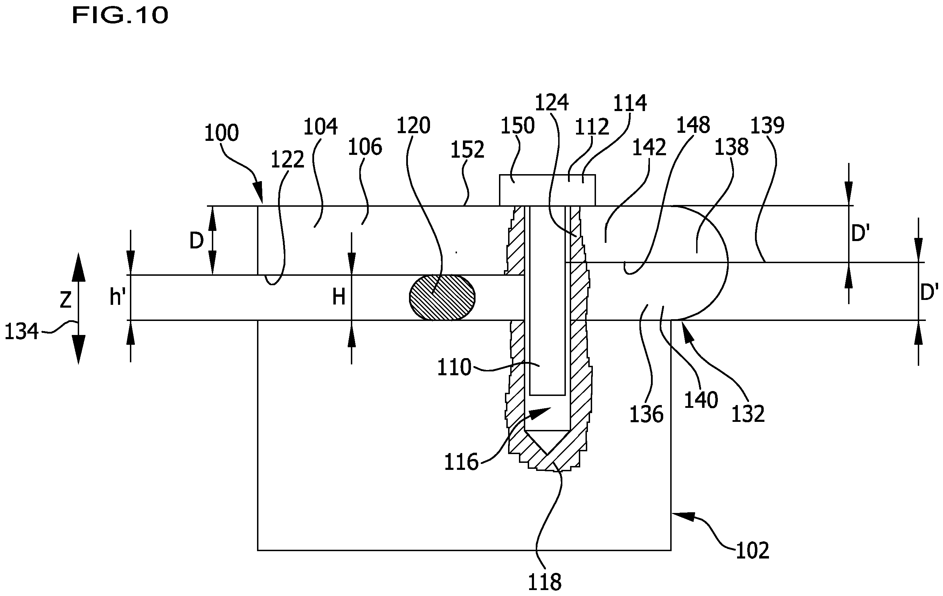

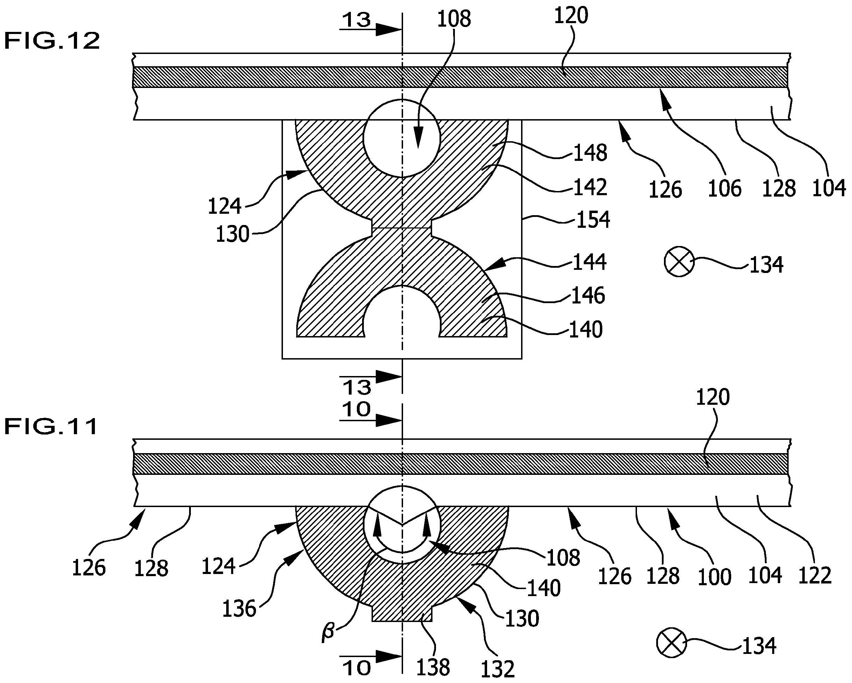

- Fig. 10: einen der Fig. 1 entsprechenden Schnitt, längs der Linie 10-10 in Fig. 11, durch einen Randbereich einer nicht erfindungsgemäßen dritten Ausführungsform eines Gehäusedeckels, bei welcher die Dicke des Umlagebereichs gleich groß ist wie die Dicke des Anlagebereichs und die Dicken des Umlagebereichs und des Anlagebereichs kleiner sind als die Dicke des Dichtungstragebereichs;
- Fig. 11: eine Draufsicht auf den Randbereich des Gehäusedeckels aus Fig. 10, mit der Blickrichtung auf die Dichtungstragefläche;
- Fig. 12: eine Draufsicht auf eine Gehäusedeckel-Vorform der dritten Ausführungsform eines Gehäusedeckels aus den Fig. 10 und 11, mit der Blickrichtung auf die Dichtungstragefläche;

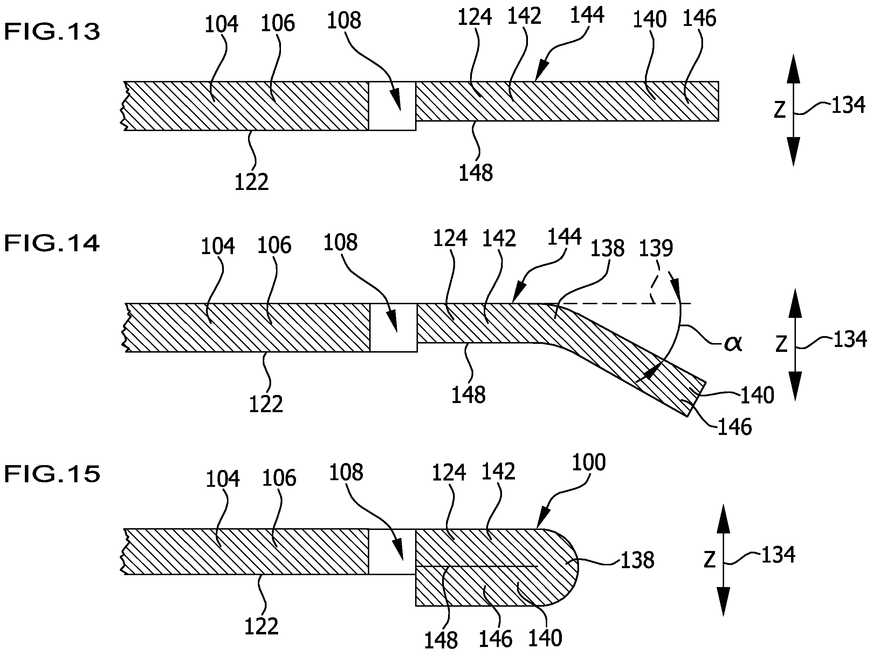

- Fig. 13: einen Schnitt durch den Randbereich der Gehäusedeckel-Vorform aus Fig. 12, längs der Linie 13 - 13 in Fig. 12, wobei die Dicke des Umlagebereichs und die Dicke des Anlagebereichs durch einen Planiervorgang gegenüber der Dicke des Dichtungstragebereichs reduziert worden sind;
- Fig. 14: einen der Fig. 13 entsprechenden Schnitt durch den Randbereich der Gehäusedeckel-Vorform, nachdem ein Biegevorgang zur Erzeugung des Biegebereichs begonnen worden ist und Material des Verformungsbegrenzungselements in dem Biegebereich um einen spitzen Winkel α aus einer parallel zu der Dichtungstragefläche verlaufenden Bezugsebene herausgebogen worden ist;
- Fig. 15: einen den Fig. 13 und 14 entsprechenden Schnitt durch den Randbereich der dritten Ausführungsform des Gehäusedeckels, nachdem der Biegevorgang zur Erzeugung des Biegebereichs abgeschlossen ist, Material des Verformungsbegrenzungselements in dem Biegebereich um einen Biegewinkel von 180° aus der parallel zu der Dichtungstragefläche verlaufenden Bezugsebene herausgebogen worden ist und der Umlagebereich flächig an dem Anlagebereich des Gehäusedeckels anliegt;

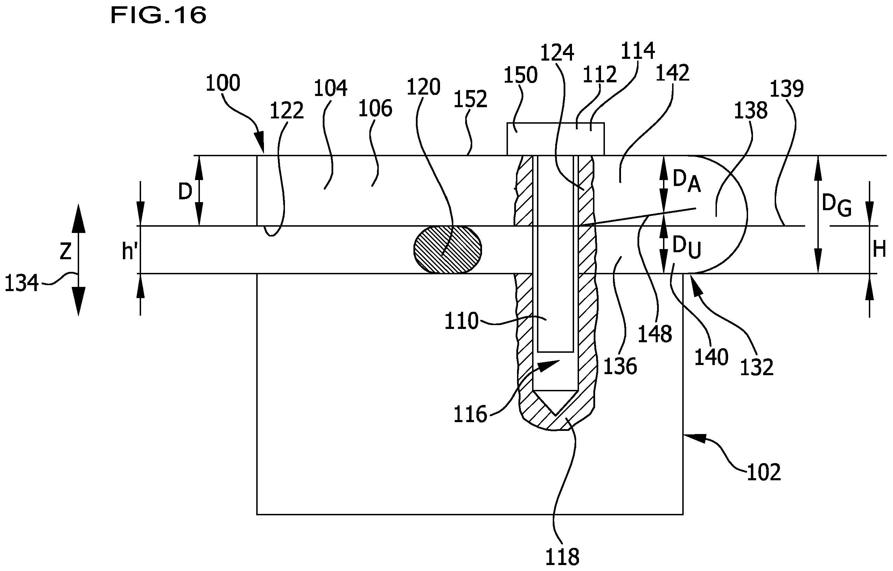

- Fig. 16: einen der Fig. 1 entsprechenden Schnitt durch einen Randbereich einer nicht erfindungsgemäßen vierten Ausführungsform eines Gehäusedeckels, bei welcher die Dicke des Umlagebereichs mit wachsendem Abstand von dem Biegebereich abnimmt und die Dicke des Anlagebereichs mit wachsendem Abstand von dem Biegebereich zunimmt, so dass die Summe der lokalen Dicke des Umlagebereichs und der lokalen Dicke des Anlagebereichs unabhängig vom Abstand vom Biegebereich im Wesentlichen konstant ist;

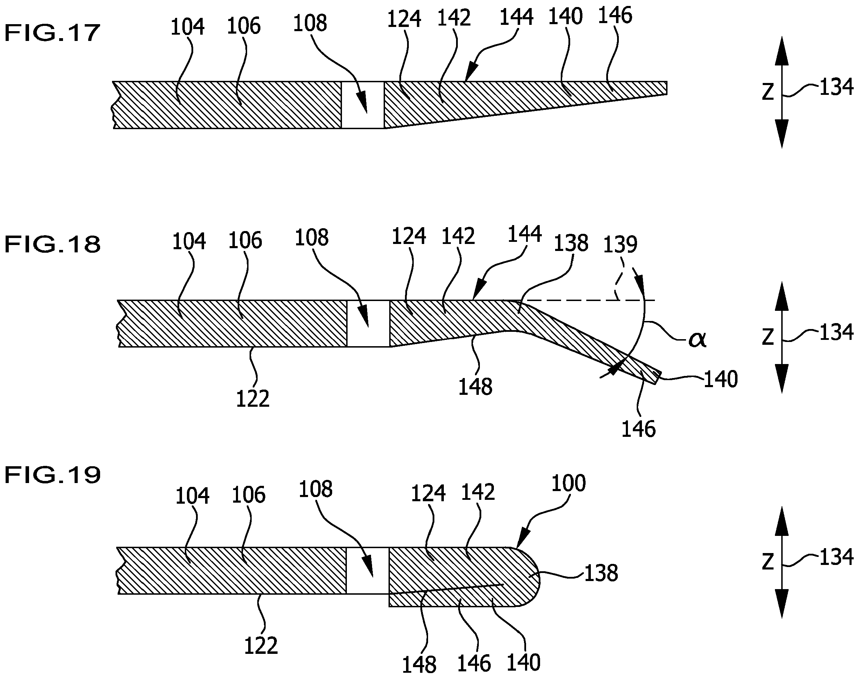

- Fig. 17: einen Schnitt durch einen Randbereich einer Gehäusedeckel-Vorform der vierten Ausführungsform eines Gehäusedeckels aus Fig. 16, bei welcher die Dicke des Anlagebereichs und die Dicke des Umlagebereichs mit wachsendem Abstand von dem Dichtungstragebereich, vorzugsweise im Wesentlichen kontinuierlich, insbesondere linear, abnimmt;
- Fig. 18: einen der Fig. 17 entsprechenden Schnitt durch den Randbereich der Gehäusedeckel-Vorform aus Fig. 17 nach dem Beginn eines Biegevorgangs zur Erzeugung des Biegebereichs, wobei in dem Biegebereich Material des Verformungsbegrenzungselements um einen spitzen Winkel α aus einer parallel zu der Dichtungstragefläche verlaufenden Bezugsebene herausgebogen worden ist;
- Fig. 19: einen der Fig. 17 und 18 entsprechenden Schnitt durch einen Randabschnitt der vierten Ausführungsform eines Gehäusedeckels, nachdem der Biegevorgang zur Erzeugung des Biegebereichs abgeschlossen ist, Material des Verformungsbegrenzungselements in dem Biegebereich um einen Biegewinkel von 180° aus der Ebene der parallel zu der Dichtungstragefläche verlaufenden Bezugsebene herausgebogen worden ist und der Umlagebereich flächig an dem Anlagebereich anliegt;

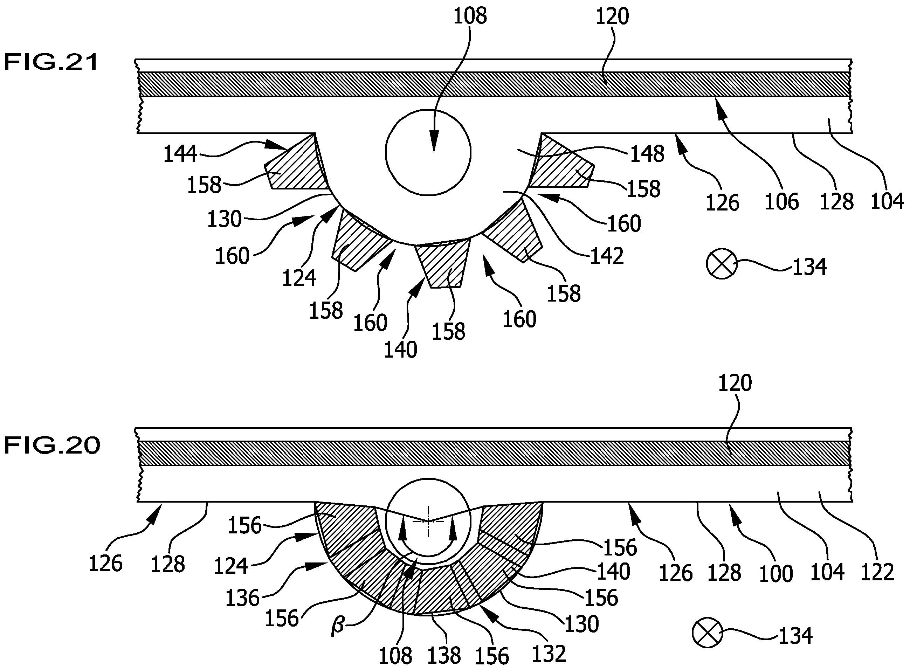

- Fig. 20: eine Draufsicht auf einen Randabschnitt einer erfindungsgemäßen fünften Ausführungsform eines Gehäusedeckels, bei welcher das Verformungsbegrenzungselement einen Befestigungsmittel-Durchtrittsöffnungs-Abschnitt umfasst, der sich längs einer Umfangsrichtung einer der Befestigungsmittel-Durchtrittsöffnungen über einen Umfangswinkel von ungefähr 180° um die betreffende Befestigungsmittel-Durchtrittsöffnung herum erstreckt und der Befestigungsmittel-Durchtrittsöffnungs-Abschnitt des Verformungsbegrenzungselements mehrere, beispielsweise fünf, Segmente umfasst, die miteinander verpresst sind, mit der Blickrichtung auf die Dichtungstragefläche des Gehäusedeckels;
- Fig. 21: eine der Fig. 20 entsprechende Draufsicht auf einen Randabschnitt einer Gehäusedeckel-Vorform, deren Umlagebereich mehrere Segmente umfasst, die in der Umfangsrichtung einer Befestigungsmittel-Durchtrittsöffnung aufeinander folgen und durch jeweils eine dazwischenliegende Lücke voneinander beabstandet sind, mit der Blickrichtung auf die Dichtungstragefläche der Gehäusedeckel-Vorform;

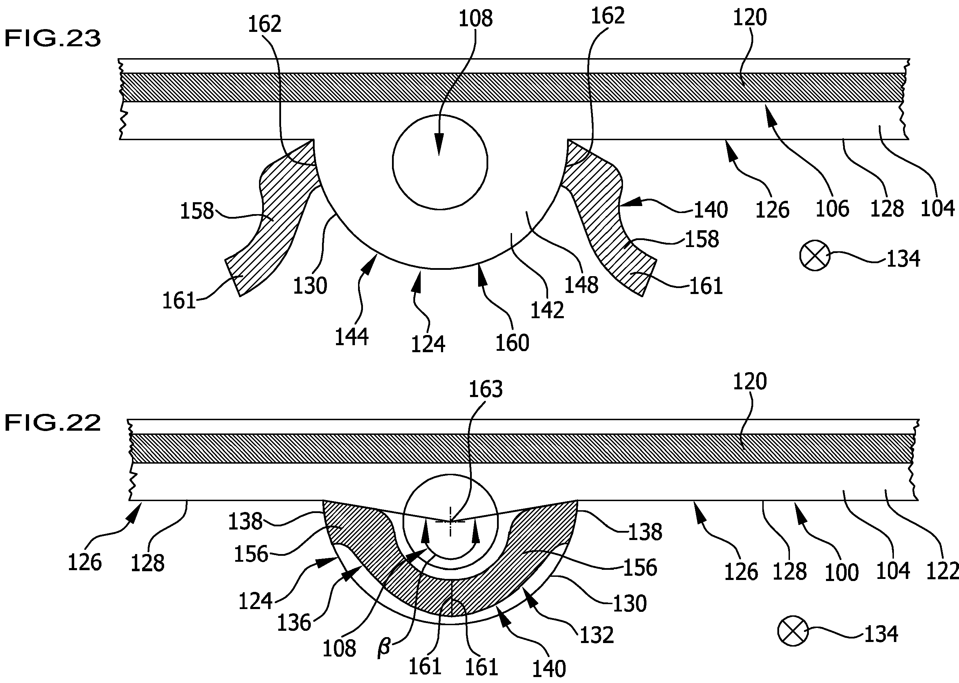

- Fig. 22: eine Draufsicht auf einen Randabschnitt einer erfindungsgemäßen sechsten Ausführungsform eines Gehäusedeckels, bei welcher das Verformungsbegrenzungselement einen Befestigungsmittel-Durchtrittsöffnungs-Abschnitt umfasst, der sich längs einer Umfangsrichtung einer Befestigungsmittel-Durchtrittsöffnungen über einen Umfangswinkel von ungefähr 180° um die betreffende Befestigungsmittel-Durchtrittsöffnung herum erstreckt, wobei der Befestigungsmittel-Durchtrittsöffnungs-Abschnitt zwei Segmente umfasst, die im betriebsfertigen Zustand der Dichtung aneinander anliegen;
- Fig. 23: eine der Fig. 22 entsprechende Draufsicht auf einen Randabschnitt einer Gehäusedeckel-Vorform der sechsten Ausführungsform eines Gehäusedeckels aus Fig. 22, wobei der Umlagebereich der Gehäusedeckel-Vorform zwei Segmente umfasst, die in der Umfangsrichtung einer Befestigungsmittel-Durchtrittsöffnung aufeinander folgen und durch eine dazwischenliegende Lücke voneinander beabstandet sind, mit der Blickrichtung auf die Dichtungstragefläche der Gehäusedeckel-Vorform;

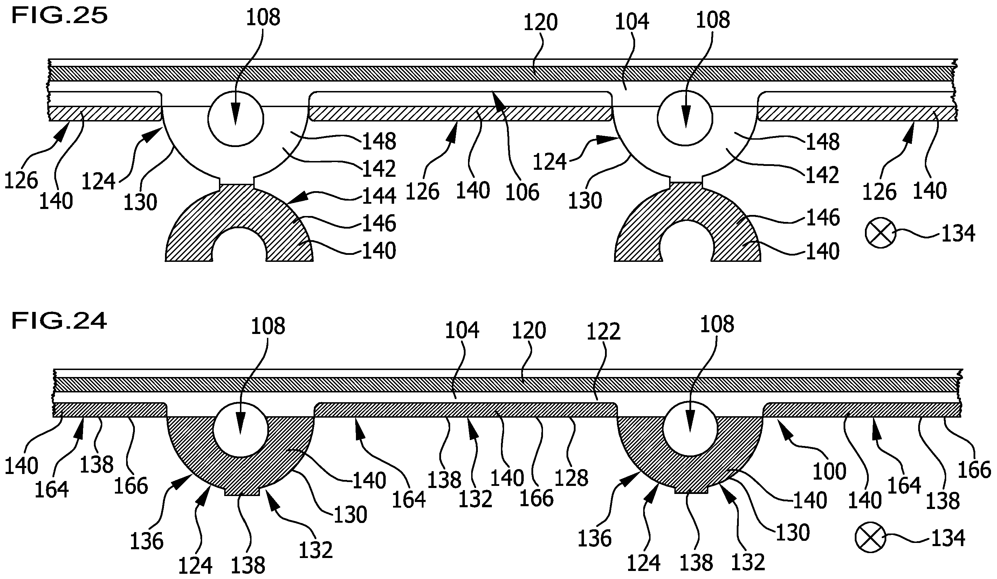

- Fig. 24: eine Draufsicht auf einen Randbereich einer nicht erfindungsgemäßen siebten Ausführungsform eines Gehäusedeckels, bei welchem das Verformungsbegrenzungselement mehrere Befestigungsmittel-Durchtrittsöffnungs-Abschnitte umfasst, die sich jeweils längs einer Umfangsrichtung einer der Befestigungsmittel-Durchtrittsöffnungen über einen Umfangswinkel um die betreffende Befestigungsmittel-Durchtrittsöffnung erstrecken und wobei des Verformungsbegrenzungselement ferner Zwischen-Befestigungsmittel-Durchtrittsöffnungs-Abschnitte umfasst, die sich jeweils längs einer Umfangsrichtung eines zwischen zwei der Befestigungsmittel-Durchtrittsöffnungen liegenden Randabschnitts des Gehäusedeckels erstrecken, wobei die Zwischen-Befestigungsmittel-Durchtrittsöffnungs-Abschnitte des Verformungsbegrenzungselements jeweils einteilig ausgebildet sind, mit der Blickrichtung auf die Dichtungstragefläche des Gehäusedeckels;
- Fig. 25: eine der Fig. 24 entsprechende Draufsicht auf einen Randbereich einer Gehäusedeckel-Vorform der siebten Ausführungsform eines Gehäusedeckels aus Fig. 24, welche die Umlagebereiche der Befestigungsmittel-Durchtrittsöffnungs-Abschnitte und der Zwischen-Befestigungsmittel-Durchtrittsöffnungs-Abschnitte des Verformungsbegrenzungselements vor dem Biegevorgang zeigt, durch welchen die Biegebereiche des Gehäusedeckels erzeugt werden;

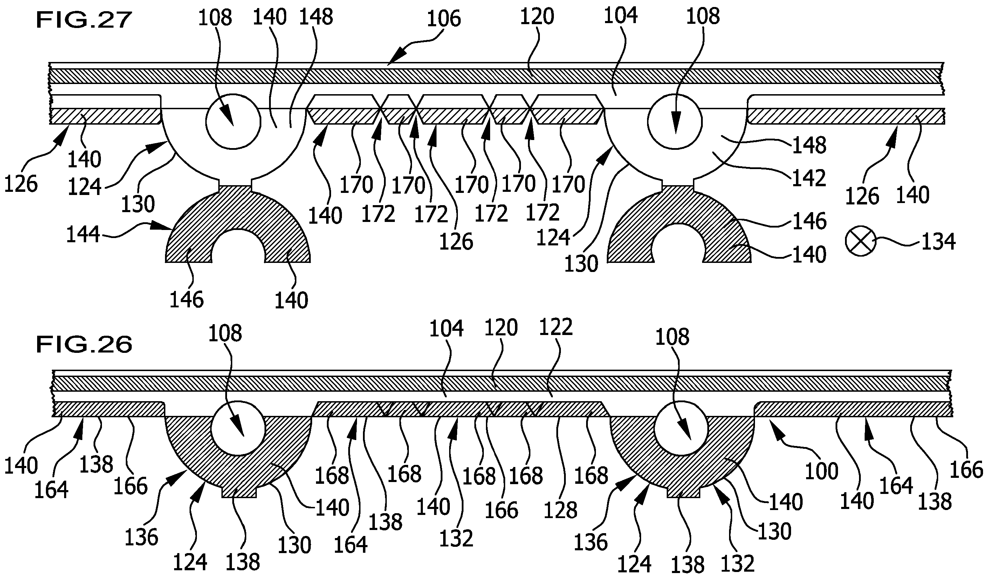

- Fig. 26: eine Draufsicht auf einen Randbereich einer erfindungsgemäßen achten Ausführungsform eines Gehäusedeckels, bei welchem das Verformungsbegrenzungselement mehrere Befestigungsmittel-Durchtrittsöffnungs-Abschnitte umfasst, die sich jeweils längs einer Umfangsrichtung einer der Befestigungsmittel-Durchtrittsöffnungen über einen Umfangswinkel um die betreffende Befestigungsmittel-Durchtrittsöffnung erstrecken, und das Verformungsbegrenzungselement mehrere Zwischen-Befestigungsmittel-Durchtrittsöffnungs-Abschnitte umfasst, die sich jeweils längs einer Umfangsrichtung eines zwischen zwei der Befestigungsmittel-Durchtrittsöffnungen liegenden Randabschnitts des Gehäusedeckels erstrecken, wobei die Befestigungsmittel-Durchtrittsöffnungs-Abschnitte des Verformungsbegrenzungselement einteilig ausgebildet sind und mindestens ein Zwischen-Befestigungsmittel-Durchtrittsöffnungs-Abschnitt des Verformungsbegrenzungselements mehrere Segmente umfasst, die längs der Umfangsrichtung eines Randabschnitts des Gehäusedeckels aufeinander folgen und miteinander verpresst sind, mit der Blickrichtung auf die Dichtungstragefläche des Gehäusedeckels;
- Fig. 27: eine der Fig. 26 entsprechende Draufsicht auf einen Randbereich einer Gehäusedeckel-Vorform der achten Ausführungsform eines Gehäusedeckels aus Fig. 26, wobei ein Umlagebereich mindestens eines der Zwischen-Befestigungsmittel-Durchtrittsöffnungs-Abschnitte des Verformungsbegrenzungselements mehrere Segmente umfasst, die in der Umfangsrichtung eines Randabschnitts der Gehäusedeckel-Vorform aufeinander folgen, wobei zwischen jeweils zwei Segmenten jeweils eine Lücke angeordnet ist, mit der Blickrichtung auf die Dichtungstragefläche der Gehäusedeckel-Vorform;

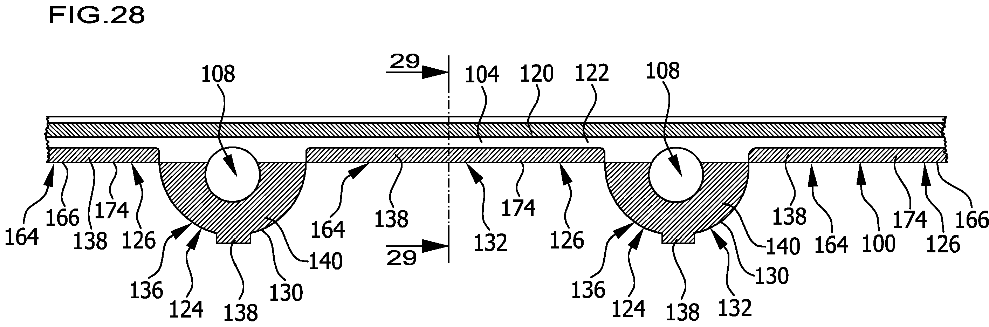

- Fig. 28: eine Draufsicht auf einen Randabschnitt einer nicht erfindungsgemäßen neunten Ausführungsform eines Gehäusedeckels, bei welchem das Verformungsbegrenzungselement mehrere Befestigungsmittel-Durchtrittsöffnungs-Abschnitte umfasst, die sich jeweils längs einer Umfangsrichtung einer der Befestigungsmittel-Durchtrittsöffnungen über einen Umfangswinkel um die jeweilige Befestigungsmittel-Durchtrittsöffnung erstrecken, und das Verformungsbegrenzungselement ferner mehrere Zwischen-Befestigungsmittel-Durchtrittsöffnungs-Abschnitte umfasst, die sich jeweils längs einer Umfangsrichtung eines zwischen zwei der Befestigungsmittel-Durchtrittsöffnungen liegenden Randabschnitts des Gehäusedeckels erstrecken und jeweils einen Biegebereich umfassen, in welchem das Material des Verformungsbegrenzungselements um einen Biegewinkel von im Wesentlichen 90° aus einer parallel zu der Dichtungstragefläche verlaufenden Bezugsebene herausgebogen ist und an einer Stirnfläche endet, mit welcher der Gehäusedeckel an das Gehäuse anlegbar ist, mit der Blickrichtung auf die Dichtungstragefläche des Gehäusedeckels;

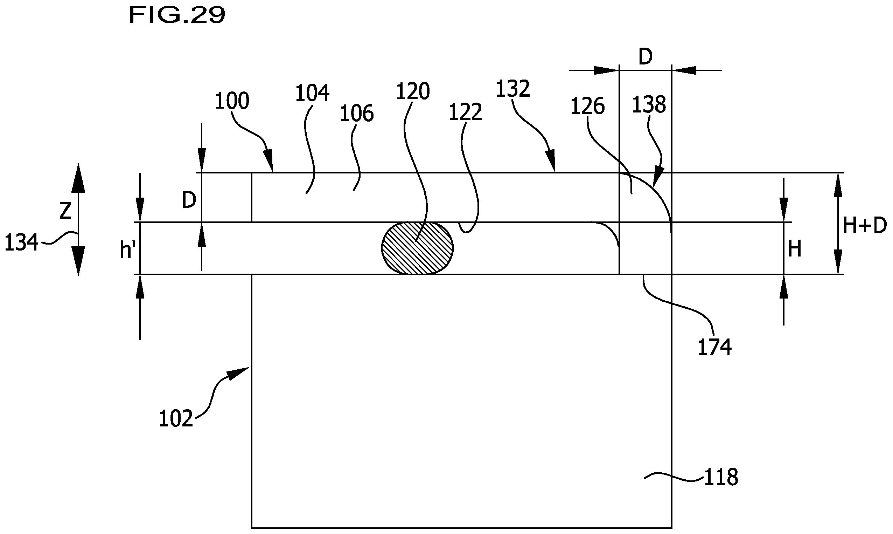

- Fig. 29: einen Schnitt durch den Randbereich des Gehäusedeckels aus Fig. 28, längs der Linie 29 - 29 in Fig. 28;

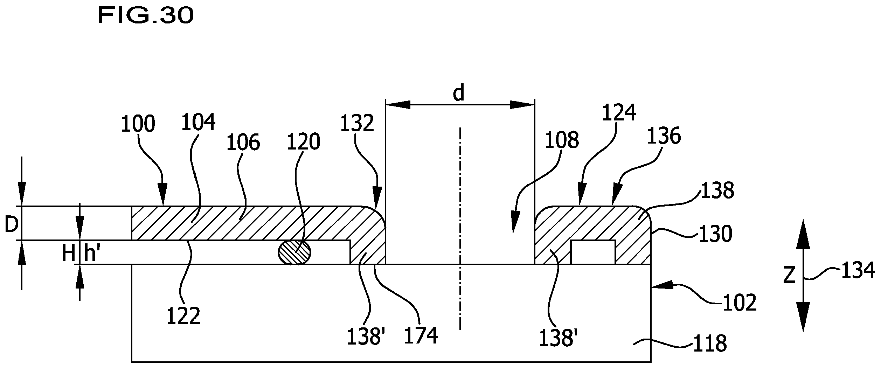

- Fig. 30: einen Schnitt durch einen Randbereich einer nicht erfindungsgemäßen zehnten Ausführungsform eines Gehäusedeckels, bei welchem das Verformungsbegrenzungselement an einem äußeren Rand des Gehäusedeckels verlaufende Biegebereiche mit einem Biegewinkel von im Wesentlichen 90° und an den Rändern der Befestigungsmittel-Durchtrittsöffnungen des Gehäusedeckels verlaufende Biegebereiche mit einem Biegewinkel von im Wesentlichen 90° umfasst; und

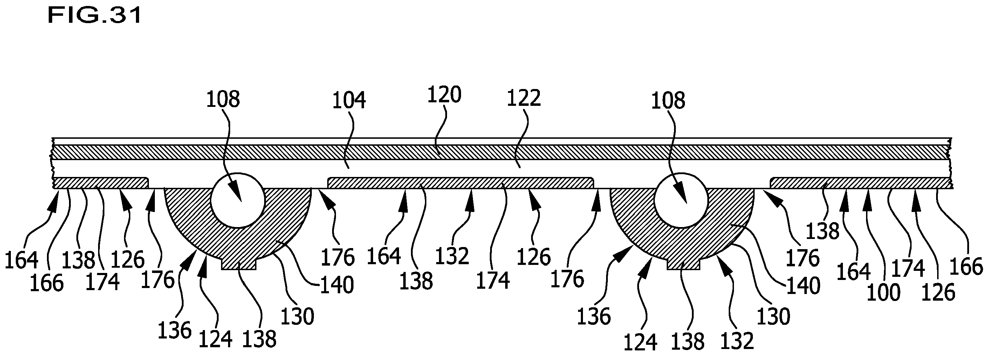

- Fig. 31: eine der Fig. 28 entsprechende Draufsicht auf einen Randabschnitt einer nicht erfindungsgemäßen elften Ausführungsform eines Gehäusedeckels, bei welchem das Verformungsbegrenzungselement mehrere Befestigungsmittel-Durchtrittsöffnungs-Abschnitte umfasst, die sich jeweils längs einer Umfangsrichtung einer der Befestigungsmittel-Durchtrittsöffnungen über einen Umfangswinkel um die jeweilige Befestigungsmittel-Durchtrittsöffnung erstrecken, und das Verformungsbegrenzungselement ferner mehrere Zwischen-Befestigungsmittel-Durchtrittsöffnungs-Abschnitte umfasst, die sich jeweils längs einer Umfangsrichtung eines zwischen zwei der Befestigungsmittel-Durchtrittsöffnungen liegenden Randabschnitts des Gehäusedeckels erstrecken und jeweils einen Biegebereich umfassen, in welchem das Material des Verformungsbegrenzungselements um einen Biegewinkel von im Wesentlichen 90° aus einer parallel zu der Dichtungstragefläche verlaufenden Bezugsebene herausgebogen ist und an einer Stirnfläche endet, mit welcher der Gehäusedeckel an das Gehäuse anlegbar ist, mit der Blickrichtung auf die Dichtungstragefläche des Gehäusedeckels, wobei zwischen jeweils einem Zwischen-Befestigungsmittel-Durchtrittsöffnungs-Abschnitt des Verformungsbegrenzungselements und einem benachbarten Befestigungsmittel-Durchtrittsöffnungs-Abschnitt des Verformungsbegrenzungselements jeweils eine Ablauföffnung ausgebildet ist, durch welche Feuchtigkeit oder Flüssigkeit aus dem Zwischenbereich zwischen dem Dichtungswulst und dem Zwischen-Befestigungsmittel-Durchtrittsöffnungs-Abschnitt des Verformungsbegrenzungselements in den Außenraum des Gehäusedeckels ablaufen kann.

Gleiche oder funktional äquivalente Elemente sind in allen Figuren mit denselben Bezugszeichen bezeichnet.

Ein in den Fig. 1 und 2 ausschnittsweise dargestellter, als Ganzes mit 100 bezeichneter Gehäusedeckel ist zum Verschließen einer Gehäuseöffnung an einem Gehäuse 102, beispielsweise an einem Gehäuse einer Steuervorrichtung oder eines Wechselrichters, insbesondere eines Wechselrichters einer Antriebsvorrichtung für ein Elektro-Automobil, vorgesehen.

Der in den Zeichnungen beispielhaft dargestellte Gehäusedeckel 100 umfasst eine metallische Grundplatte 104 mit einem vorzugsweise im Wesentlichen ebenen Dichtungstragebereich 106.

Längs des äußeren Umfangs des Dichtungstragebereichs 106 des Gehäusedeckels 100 ist der Gehäusedeckel 100 mit mehreren Befestigungsmittel-Durchtrittsöffnungen 108 versehen, welche längs des Umfangs des Gehäusedeckels 100 im Abstand voneinander aufeinanderfolgen.

Diese Befestigungsmittel-Durchtrittsöffnungen 108 dienen bei der Montage des Gehäusedeckels 100 an dem zu verschließenden Gehäuse 102 zur Aufnahme der Schäfte 110 von Befestigungsmitteln 112, vorzugsweise in Form von Befestigungsschrauben 114 (siehe die Fig. 1, welche den Gehäusedeckel 100 in seinem mittels der Befestigungsmittel 112 an dem Gehäuse 102 montierten Zustand darstellt), welche sich durch die Befestigungsmittel-Durchtrittsöffnungen 108 hindurch erstrecken und mit ihren Außengewinden in korrespondierende Innengewinde von Gewindelöchern 116 in Befestigungsmittel-Montagebereichen 118 des zu verschließenden Gehäuses 102 eingeschraubt werden.

Eine oder mehrere der Befestigungsmittel-Durchtrittsöffnungen 108 sind vorzugsweise zumindest teilweise in jeweils einem Befestigungsmittel-Durchtrittsöffnungs-Bereich 124 des Gehäusedeckels 100 angeordnet, welcher zwischen zwei Zwischen-Befestigungsmittel-Durchtrittsöffnungs-Bereichen 126 des Gehäusedeckels 100 angeordnet ist und welcher über einen äußeren Rand 128 der angrenzenden Zwischen-Befestigungsmittel-Durchtrittsöffnungs-Bereiche 126 nach außen vorspringt. Der äußere Rand 130 des Befestigungsmittel-Durchtrittsöffnungs-Bereichs 124 verläuft vorzugsweise im Wesentlichen längs der Umfangsrichtung der jeweiligen Befestigungsmittel-Durchtrittsöffnung 108.

Zur fluiddichten Abdichtung zwischen dem Gehäusedeckel 100 und dem zu verschließenden Gehäuse 102 ist ein Dichtungswulst 120 vorgesehen, welcher an einer im montierten Zustand des Gehäusedeckels 100 dem Innenraum des zu verschließenden Gehäuses 102 zugewandten Innenseite des Gehäusedeckels 100, welche eine Dichtungstragefläche 122 des Gehäusedeckels 100 bildet, angeordnet ist.

Der Dichtungswulst 120 verläuft längs des Randes des Gehäusedeckels 100 und ist vorzugsweise ringförmig geschlossen ausgebildet.

Der Dichtungswulst 120 ist aus einem Elastomermaterial, beispielsweise aus einem Silikonmaterial, gebildet und kann beispielsweise durch Auftragen mittels eines Dispensers (in einem sogenannten CIP("Cured-in-Place")-Verfahren) oder durch ein Siebdruckverfahren an der Dichtungstragefläche 122 gebildet werden.

Bei der Montage des Gehäusedeckels 100 an dem Gehäuse 102 mittels der Befestigungsmittel 112 wird durch Anziehen der Befestigungsmittel 112 in den Gewindelöchern 116 der Befestigungsmittel-Montagebereiche 118 des Gehäuses 102 der Dichtungswulst 120 verpresst, wobei sich die Höhe des Dichtungswulstes 120, das heißt dessen Ausdehnung senkrecht zu der Dichtungstragefläche 122, von der Höhe h im unbelasteten Zustand auf einen Wert h' im montierten Zustand verringert.

Die elastische Rückstellkraft des elastomeren Dichtungswulstes 120 erzeugt dann die Abdichtkraft, mit welcher der Dichtungswulst 120 abdichtend an dem Gehäuse 102 anliegt.

Um eine übermäßige Verformung des Dichtungswulstes 120 zu vermeiden, umfasst der Gehäusedeckel 100 ein oder mehrere Verformungsbegrenzungselemente 132, welche über die Dichtungstragefläche 122 in derselben Richtung, nämlich in einer senkrecht zur Dichtungstragefläche 122 ausgerichteten Z-Richtung 134, vorstehen wie der Dichtungswulst 120 und eine Verformung des Dichtungswulstes 120 im montierten Zustand des Gehäusedeckels 100 begrenzen.

Das Verformungsbegrenzungselement 132 ist steifer als der Dichtungswulst 120 ausgebildet, vorzugsweise im Wesentlichen starr, so dass die Höhe h' des Dichtungswulstes 120 im verpressten Zustand desselben nach unten durch die Höhe H des Verformungsbegrenzungselements 132 über der Dichtungstragefläche 122 begrenzt ist.

Mindestens eines der Verformungsbegrenzungselemente 132 umfasst einen Befestigungsmittel-Durchtrittsöffnungs-Abschnitt 136, der sich längs einer Umfangsrichtung einer jeweils zugeordneten Befestigungsmittel-Durchtrittsöffnung 108 über einen Umfangswinkel β um die betreffende Befestigungsmittel-Durchtrittsöffnung 108 herum erstreckt.

Der Umfangswinkel β beträgt vorzugsweise mehr als 90°, insbesondere mehr als 120°, besonders bevorzugt mehr als 160°.

Ferner beträgt der Umfangswinkel β vorzugsweise weniger als 270°, insbesondere weniger als 200°.

Wie am besten aus Fig. 1 zu ersehen ist, umfasst das Verformungsbegrenzungselement 132 einen Biegebereich 138, in welchem das Material des Verformungsbegrenzungselements 132 um einen Biegewinkel α von ungefähr 180° aus einer parallel zu der Dichtungstragefläche 122 verlaufenden Bezugsebene 139 herausgebogen ist.

Das Verformungsbegrenzungselement 132 umfasst ferner einen Umlagebereich 140, welcher, vorzugsweise einstückig, über den Biegebereich 138 und einen Anlagebereich 142 des Gehäusedeckels 100 mit dem Dichtungstragebereich 106 des Gehäusedeckels 100, an welchem der Dichtungswulst 120 angeordnet ist, verbunden ist.

Der Umlagebereich 140 liegt an dem Anlagebereich 142 auf derselben Seite des Gehäusedeckels 100 an, auf welcher auch der Dichtungswulst 120 an dem Gehäusedeckel 100 angeordnet ist.

Vorzugsweise liegt der Umlagebereich 140 flächig, besonders bevorzugt im Wesentlichen vollflächig, an dem Anlagebereich 142 an.

Der Gehäusedeckel 100 ist aus einem Ausgangsmaterial, insbesondere aus einem metallischen Blechmaterial, gebildet, das eine Materialstärke oder Dicke D aufweist, welche vorzugsweise kleiner ist als 1,5 mm.

Die Dicke D des Ausgangsmaterials des Gehäusedeckels 100 beträgt insbesondere weniger als 1,4 mm, besonders bevorzugt weniger als 1,2 mm, beispielsweise ungefähr 1,0 mm.

Aus diesem Ausgangsmaterial wird der Gehäusedeckel 100 einschließlich des Verformungsbegrenzungselements 132 wie folgt hergestellt:
Aus dem metallischen Ausgangsmaterial wird eine in Fig. 3 ausschnittsweise dargestellte Gehäusedeckel-Vorform 144 herausgetrennt.

Das Heraustrennen kann beispielsweise durch Ausschneiden, beispielsweise mittels eines Lasers, oder durch Ausstanzen erfolgen.

Die Gehäusedeckel-Vorform 144 umfasst eine Lasche 146, welche den Umlagebereich 140 und einen Teil des späteren Biegebereichs 138 des Verformungsbegrenzungselements 132 umfasst (in Fig. 3 durch Schraffur gekennzeichnet).

Durch Ausführen eines Biegevorgangs wird der Umlagebereich 140 und ein Teil des Biegebereichs 138 aus der Ebene des Ausgangsmaterials hochgestellt, und anschließend wird der Umlagebereich 140 auf die ihm zugewandte Anlagefläche 148 des Anlagebereichs 142 umgelegt.

Der auf den Anlagebereich 142 umgelegte Umlagebereich 140 wird mit dem Anlagebereich 142 verpresst.

Im fertigen Zustand des Gehäusedeckels 100 liegt der Umlagebereich 140 im Wesentlichen flächig an der Anlagefläche 148 des Anlagebereichs 142 an, und der Biegewinkel α des Biegebereichs 138 beträgt im Wesentlichen 180°.

Grundsätzlich könnte vorgesehen sein, dass der Umlagebereich 140 die Befestigungsmittel-Durchtrittsöffnung 108 vollständig umschließt.

Bei der zeichnerisch dargestellten Ausführungsform ist jedoch vorgesehen, dass der Umlagebereich 140 die Befestigungsmittel-Durchtrittsöffnung 108 nicht vollständig umschließt, sondern nur über einen Umfangswinkel β von weniger als 360°, vorzugsweise von weniger als 270°, jeweils bezogen auf die Längsmittelachse der Befestigungsmittel-Durchtrittsöffnung 108, berandet.

Hierdurch wird erreicht, dass kein Anteil des Umlagebereichs 140 zwischen der Befestigungsmittel-Durchtrittsöffnung 108 einerseits und dem Dichtungswulst 120 andererseits angeordnet ist, so dass der Dichtungswulst 120 sehr nahe an der Befestigungsmittel-Durchtrittsöffnung 108 vorbei geführt werden kann, damit eine möglichst hohe Anpresskraft von dem Kopf 150 des Befestigungsmittels 112 über den Dichtungstragebereich 106 des Gehäusedeckels 100 auf den Dichtungswulst 120 übertragen werden kann.

Der Kopf 150 des Befestigungsmittels 112 liegt vorzugsweise im Wesentlichen vollflächig an einer der Dichtungstragefläche 122 abgewandten Befestigungsmittel-Anlagefläche 152 des Gehäusedeckels 102 an, welche vorzugsweise im Wesentlichen eben ausgebildet ist.

Wie am besten aus Fig. 1 zu ersehen ist, weisen bei dieser Ausführungsform des Gehäusedeckels 100 der Umlagebereich 140, der Anlagebereich 142 und der Dichtungstragebereich 106 des Gehäusedeckels 100 jeweils die Dicke D auf, welche der Dicke oder Materialstärke des metallischen Ausgangsmaterials entspricht.

Die Höhe H des Verformungsbegrenzungselements 132 über der Dichtungstragefläche 122 ist bei dieser Ausführungsform gleich groß wie die Dicke D des Ausgangsmaterials und damit gleich groß wie die Dicke des Anlagebereichs 142 und die Dicke des Dichtungstragebereichs 106 des Gehäusedeckels 100.

Durch das Verformungsbegrenzungselement 132, auch als Stopper bezeichnet, wird bei der Montage des Gehäusedeckels 100 an dem Gehäuse 102 der Dichtungswulst 120 auf das definierte Maß h' verpresst, welches der Höhe H des Verformungsbegrenzungselements 132 über der Dichtungstragefläche 122 entspricht.

Hierdurch wird ein Überpressen des Dichtungswulstes 120 verhindert.

Das metallische Ausgangsmaterial, aus welchem der Gehäusedeckel 100 hergestellt wird, kann insbesondere Aluminium oder eine Aluminium-Legierung umfassen.

Alternativ hierzu kann auch vorgesehen sein, dass das Ausgangsmaterial, aus welchem der Gehäusedeckel 100 gebildet wird, ein Edelstahlmaterial ist.

Grundsätzlich kommt aber auch jedes andere blechförmige, insbesondere metallische, Ausgangsmaterial für die Herstellung des Gehäusedeckels 100 in Betracht.

Eine in den Fig. 4 bis 9 dargestellte zweite Ausführungsform eines Gehäusedeckels 100 unterscheidet sich von der vorstehend beschriebenen, in den Fig. 1 bis 3 dargestellten Ausführungsform dadurch, dass die Dicke D' des Umlagebereichs 140 des Verformungsbegrenzungselements 132 und damit die Höhe H des Verformungsbegrenzungselements 132 über der Dichtungstragefläche 122 kleiner ist als die Dicke D des Anlagebereichs 142 und des Dichtungstragebereichs 106, welche mit der Dicke D des Ausgangsmaterials übereinstimmen.

Dies wird dadurch erreicht, dass ein in Fig. 6 innerhalb des dort dargestellten Rahmens 154 liegender Bereich des Ausgangsmaterials planiert wird, bevor die Gehäusedeckel-Vorform 144 aus dem Ausgangsmaterial herausgetrennt wird.

Dabei wird durch das Planieren des Ausgangsmaterials die Dicke des Umlagebereichs 140 von dem Ausgangswert D auf den Wert D' reduziert, welcher vorzugsweise höchstens 0,9 D, insbesondere höchstens 0,8 D, besonders bevorzugt höchstens 0,7 D, entspricht.

Der Planiervorgang erfolgt dabei von der Blattinnenseite in Richtung auf die Blattaußenseite des in Blattform vorliegenden Ausgangsmaterials, so dass beim nachfolgenden Biegevorgang keine Höhendifferenz oder Kante zu überwinden ist.

Auf diese Weise kann ein platzsparendes Verformungsbegrenzungselement 132 mit einer Höhe H erzeugt werden, welche geringer ist als die Dicke D des Ausgangsmaterials, ohne in die Werkstoffstruktur des Materials des Gehäusedeckels 100 einzugreifen, da die Blechumlage von außen nach innen gestellt wird.

Der Umformgrad im Umlagebereich 140 ist bei dieser Ausführungsform jedoch relativ hoch.

Bei der Herstellung der zweiten Ausführungsform des Gehäusedeckels wird wie folgt vorgegangen:
Zunächst wird das Ausgangsmaterial in dem durch den Rahmen 154 in Fig. 6 markierten Bereich planiert, um die Materialstärke im Umlagebereich 140 zu reduzieren. Nach dem Planiervorgang wird die Gehäusedeckel-Vorform 144 aus dem Ausgangsmaterial herausgetrennt (siehe Fig. 7).

Beispielsweise kann beim Planiervorgang die Dicke des Ausgangsmaterials im Umlagebereich 140 von 1,5 mm auf 1,0 mm reduziert werden.

In einem anschließenden Biegevorgang werden ein Teil des Materials des Biegebereichs 138 und der Umlagebereich 140 aus der parallel zu der Dichtungstragefläche 122 verlaufenden Bezugsebene 139 herausgebogen (siehe Fig. 8, mit dem Biegewinkel α, welcher sich im Laufe des Biegevorgangs von 0° auf 180° erhöht).

Nachdem der Biegevorgang abgeschlossen ist und der Umlagebereich 140 flächig, vorzugsweise im Wesentlichen vollflächig, an der Anlagefläche 148 des Anlagebereichs 142 anliegt, werden der Umlagebereich 140 und der Anlagebereich 142 miteinander verpresst (siehe Fig. 9).

Damit ist die Herstellung des Verformungsbegrenzungselements 132 abgeschlossen.

Nun wird der Dichtungswulst 120 an dem Dichtungstragebereich 106 des Gehäusedeckels 102 erzeugt.

Im Übrigen stimmt die in den Fig. 4 bis 9 dargestellte zweite Ausführungsform eines Gehäusedeckels 100 hinsichtlich Aufbau, Funktion und Herstellungsweise mit der in den Fig. 1 bis 3 dargestellten ersten Ausführungsform überein, auf deren vorstehende Beschreibung insoweit Bezug genommen wird.

Eine in den Fig. 10 bis 15 dargestellte dritte Ausführungsform eines Gehäusedeckels 100 unterscheidet sich von der in den Fig. 1 bis 3 dargestellten ersten Ausführungsform dadurch, dass die Dicke D' des Umlagebereichs 140 und die Dicke D' des Anlagebereichs 142 des Verformungsbegrenzungselements 132 beide kleiner sind als die Dicke D des Dichtungstragebereichs 106, welche der Dicke D des Ausgangsmaterials des Gehäusedeckels 100 entspricht.

Bei dieser Ausführungsform sind die Dicken D' des Umlagebereichs 140 und D' des Anlagebereichs 142 im Wesentlichen gleich groß.

Dies wird dadurch erreicht, dass bei dieser Ausführungsform die Dicke D des Ausgangsmaterials innerhalb des durch den Rahmen 154 in Fig. 12 definierten Bereichs, welcher den Umlagebereich 140, den Biegebereich 138 und den Anlagebereich 142 des Verformungsbegrenzungselements 132 umfasst, durch Planieren reduziert wird.

Die Planierung erfolgt innerhalb dieses Bereichs vorzugsweise mit einem konstanten Umformungsgrad.

Dabei beträgt die reduzierte Dicke D' des durch die Planierung dickenreduzierten Bereichs des Ausgangsmaterials vorzugsweise höchstens 0,9 D und/oder vorzugsweise mindestens 0,8 D, wobei D die unreduzierte Dicke des Ausgangsmaterials ist.

Durch die Reduzierung der Dicke D' des Anlagebereichs 142 gegenüber der Dicke D des Dichtungstragebereichs 106 ist bei dieser Ausführungsform des Gehäusedeckels 100 die Höhe H des Verformungsbegrenzungselements 132 und damit die Höhe h', auf welche der Dichtungswulst 120 bei der Montage des Gehäusedeckels 100 an dem Gehäuse 102 verpresst wird, kleiner als die Materialstärke D des Ausgangsmaterials und kleiner als die Dicke D' des Umlagebereichs 140.

Wird beispielsweise ein Ausgangsmaterial mit der Dicke D = 1,5 mm im Umlagebereich 140 und im Anlagebereich 142 auf beispielsweise 1,25 mm planiert, so ergibt sich eine Höhe H des Verformungsbegrenzungselements 132 über der Dichtungstragefläche 122 von 1,0 mm.

Bei der Herstellung der dritten Ausführungsform des Gehäusedeckels 100 wird wie folgt vorgegangen:
Das Ausgangsmaterial mit der Materialstärke D wird in dem durch den Rahmen 154 in Fig. 12 markierten Bereich durch einen Planiervorgang auf die geringere Dicke D' reduziert. Nach dem Planiervorgang wird die Gehäusedeckel-Vorform 144 aus dem Ausgangsmaterial herausgetrennt (siehe Fig. 13).

Ein Teil des Biegebereichs 138 und der Umlagebereich 140 werden aus der parallel zur Dichtungstragefläche 122 verlaufenden Bezugsebene 139 herausgebogen und hochgestellt (siehe Fig. 14, mit dem während des Biegevorgangs von 0° bis 180° anwachsenden Biegewinkel α).

Nachdem ein Biegewinkel α von 180° erreicht ist und der Umlagebereich 140 im Wesentlichen flächig an der Anlagefläche 148 des Anlagebereichs 142 anliegt, werden der Umlagebereich 140 und der Anlagebereich 142 miteinander verpresst (siehe Fig. 15).

Im Übrigen stimmt die in den Fig. 10 bis 15 dargestellte dritte Ausführungsform eines Gehäusedeckels 100 hinsichtlich Aufbau, Funktion und Herstellungsweise mit der in den Fig. 4 bis 9 dargestellten zweiten Ausführungsform überein, auf deren vorstehende Beschreibung insoweit Bezug genommen wird.

Eine in den Fig. 16 bis 19 dargestellte vierte Ausführungsform eines Gehäusedeckels 100 unterscheidet sich von der vorstehend beschriebenen, in den Fig. 10 bis 15 dargestellten dritten Ausführungsform dadurch, dass die Dicke D_{A} des Anlagebereichs 142 im Anlagebereich 142 nicht konstant ist, sondern mit wachsendem Abstand von dem Biegebereich 138 variiert.

Insbesondere ist vorgesehen, dass die Dicke D_{A} des Anlagebereichs 142 mit wachsendem Abstand von dem Biegebereich 138 bis auf den Wert D zunimmt, welcher der Dicke des Ausgangsmaterials und der Dicke des Dichtungstragebereichs 106 des Gehäusedeckels 100 entspricht.

Ferner ist bei dieser Ausführungsform vorgesehen, dass die Dicke D_{U} des Umlagebereichs 140 im Umlagebereich 104 nicht konstant ist, sondern mit wachsendem Abstand von dem Biegebereich 138 variiert.

Insbesondere ist vorgesehen, dass die Dicke D_{U} des Umlagebereichs 140 mit wachsendem Abstand von dem Biegebereich 138 abnimmt.

Wie am besten aus Fig. 16 zu ersehen ist, ist dabei vorzugsweise die Summe D_{G} aus der lokalen Dicke D_{U} des Umlagebereichs 140 und der lokalen Dicke D_{A} des Anlagebereichs 142 im Wesentlichen unabhängig vom Abstand von dem Biegebereich 138.

Die Höhe H des Verformungsbegrenzungselements 132 über der Dichtungstragefläche 122 entspricht bei dieser Ausführungsform der Differenz aus der Gesamtdicke D_{G} des Umlagebereichs 140 und des Anlagebereichs 142 einerseits und der Dicke D des Dichtungstragebereichs 106, welche der Dicke D des Ausgangsmaterials entspricht, andererseits.

Dies wird dadurch erreicht, dass beim Planieren des Ausgangsmaterials die Umformung so über den Anlagebereich 142, den späteren Biegebereich 138 und den Umlagebereich 140 verteilt wird, dass der Umformgrad von dem dem Dichtungstragebereich 106 zugewandten Rand des Anlagebereichs 142 bis zu dem dem Biegebereich 138 abgewandten äußeren Rand des Umlagebereichs 140, vorzugsweise im Wesentlichen kontinuierlich, besonders bevorzugt im Wesentlichen linear, zunimmt.

Dies kann beispielsweise durch Verwendung eines keilförmigen Planierwerkzeugs bewirkt werden, welches die Materialverdrängung im Anlagebereich 142 auf ein Minimum begrenzt und den hohen Umformgrad auf den Umlagebereich 140 verschiebt.

Dies bietet den Vorteil, dass überschüssiges Ausgangsmaterial nur in geringem Maß in Richtung auf den Dichtungswulst 120 und/oder in Richtung auf die Befestigungsmittel-Durchtrittsöffnung 108 gedrückt wird.

Die gewünschte Außenkontur des Umlagebereichs 140 wird trotz der hohen Materialverdrängung beim Planiervorgang dadurch erhalten, dass die Gehäusedeckel-Vorform 144 nach dem Planiervorgang aus dem Ausgangsmaterial herausgetrennt wird.

Bei der Herstellung der vierten Ausführungsform des Gehäusedeckels 100 wird wie folgt vorgegangen:
Im Ausgangsmaterial mit der Dicke D werden der Anlagebereich 142, der spätere Biegebereich 138 und der Umlagebereich 140 keilförmig planiert, und zwar von dem dem Dichtungstragebereich 106 zugewandten Rand des Anlagebereichs 142 über den späteren Biegebereich 138 bis zu dem dem Dichtungstragebereich 106 abgewandten Rand des Umlagebereichs 140, also von innen nach außen. Nach dem Planiervorgang wird die Gehäusedeckel-Vorform 144 aus dem Ausgangsmaterial herausgetrennt (siehe Fig. 17).

In einem Biegevorgang werden der Umlagebereich und ein Teil des Biegebereichs 138 aus der parallel zu der Dichtungstragefläche 122 verlaufenden Bezugsebene 139 herausgebogen (siehe Fig. 18 mit dem Biegewinkel α, welcher während des Biegevorgangs von 0° bis auf 180° zunimmt).

Wenn der Biegevorgang abgeschlossen ist und der Umlagebereich 140 flächig, vorzugsweise im Wesentlichen vollflächig, an der Anlagefläche 148 des Anlagebereichs 142 anliegt, werden der Umlagebereich 140 und der Anlagebereich 142 miteinander verpresst (siehe Fig. 19).

Im Übrigen stimmt die in den Fig. 16 bis 19 dargestellte vierte Ausführungsform eines Gehäusedeckels 100 hinsichtlich Aufbau, Funktion und Herstellungsweise mit der in den Fig. 10 bis 15 dargestellten dritten Ausführungsform überein, auf deren vorstehende Beschreibung insoweit Bezug genommen wird.

Eine in den Fig. 20 und 21 dargestellte fünfte Ausführungsform eines Gehäusedeckels 100 unterscheidet sich von den vier vorstehend beschriebenen, in den Fig. 1 bis 19 dargestellten Ausführungsformen dadurch, dass der Befestigungsmittel-Durchtrittsöffnungs-Abschnitt 136 des Verformungsbegrenzungselements 132 in seinem Umlagebereich 140 aus mehreren Segmenten 156 zusammengesetzt ist, welche durch Verpressung und daraus resultierendes Zusammenfließen des Materials der Segmente 156 einen zusammenhängenden Umlagebereich 140 des Verformungsbegrenzungselements 132 bilden.

In der in Fig. 21 dargestellten Gehäusedeckel-Vorform 144 folgen die Segment-Vorformen 158, aus denen später die Segmente 156 des Umlagebereichs 140 gebildet werden, längs der Umfangsrichtung der Befestigungsmittel-Durchtrittsöffnung 108 aufeinander, wobei zwischen jeweils zwei in der Umfangsrichtung aufeinanderfolgenden Segment-Vorformen 158 jeweils eine Lücke 160 angeordnet ist.

Die Anzahl der Segment-Vorformen 158 und damit die Anzahl der Segmente 156 beträgt vorzugsweise zwei oder mehr, insbesondere drei oder mehr, besonders bevorzugt vier oder mehr, beispielsweise fünf oder mehr.

Im dargestellten Ausführungsbeispiel sind fünf Segment-Vorformen 158 und somit auch fünf Segmente 156 im fertig hergestellten Umlagebereich 140 vorhanden.

Die Segment-Vorformen 158 stehen vorzugsweise in im Wesentlichen radialer Richtung der zugeordneten Befestigungsmittel-Durchtrittsöffnung 108 von dem Anlagebereich 142 des Gehäusedeckels 100 nach außen ab.

Bei der Herstellung der fünften Ausführungsform des Gehäusedeckels 100 wird wie folgt vorgegangen:
Wenn die Höhe H des Verformungsbegrenzungselements 132 über der Dichtungstragefläche 122 kleiner sein soll als die Dicke D des Ausgangsmaterials, werden der Anlagebereich 142, der spätere Biegebereich 138 und die Segment-Vorformen 158 des Umlagebereichs 140 so planiert, wie vorstehend im Zusammenhang mit der zweiten, dritten oder vierten Ausführungsform des Gehäusedeckels 100 beschrieben.

Die in Fig. 21 dargestellte Gehäusedeckel-Vorform 144 wird aus dem Ausgangsmaterial herausgetrennt.

Die Segment-Vorformen 158 werden aus der zur Dichtungstragefläche 122 parallelen Bezugsebene 139 herausgebogen, hochgestellt und auf die Anlagefläche 148 des Anlagebereichs 142 umgelegt, bis die Segment-Vorformen 158 flächig, vorzugsweise im Wesentlichen vollflächig, an der Anlagefläche 148 des Anlagebereichs 142 anliegen.

Dann werden der Anlagebereich 142 und die Segment-Vorformen 158 des Umlagebereichs 140 miteinander verpresst und vorzugsweise planiert, um gegebenenfalls ein Verformungsbegrenzungselement 132 mit einer gegenüber der Materialstärke D des Ausgangsmaterials reduzierten Höhe H zu erzeugen.

Durch den Pressvorgang und den gegebenenfalls erfolgenden Planiervorgang fließen die Segmente 156 des Umlagebereichs 140 ineinander und bilden einen einstückigen Umlagebereich 140, welcher eine längs der Umfangsrichtung der Befestigungsmittel-Durchtrittsöffnung 108 im Wesentlichen konstante Höhe aufweist.

Diese Höhe des Umlagebereichs 140 kann bei einer Materialstärke des Ausgangsmaterials von beispielsweise 1,5 mm beispielsweise 1,0 mm betragen.

Im Übrigen stimmt die in den Fig. 20 und 21 dargestellte fünfte Ausführungsform eines Gehäusedeckels 100 hinsichtlich Aufbau, Funktion und Herstellungsweise mit der in den Fig. 1 bis 3 dargestellten ersten Ausführungsform überein, auf deren vorstehende Beschreibung insoweit Bezug genommen wird.

Eine in den Fig. 22 und 23 dargestellte sechste Ausführungsform eines Gehäusedeckels 100 unterscheidet sich von der vorstehend beschriebenen, in den Fig. 20 und 21 dargestellten fünften Ausführungsform dadurch, dass der Umlagebereich 140 des Befestigungsmittel-Durchtrittsöffnungs-Abschnitts 136 des Verformungsbegrenzungselements 132 statt fünf ungefähr kreissektorabschnittsförmiger Segmente 156 nur zwei, beispielsweise flügelförmige, Segmente 156 umfasst.

Wie aus Fig. 22 zu ersehen ist, berühren sich die Segmente 156 des Umlagebereichs 140 an ihren Stirnseiten 161.

Beide Segmente 156 grenzen an einander - in Bezug auf die Längsmittelachse 163 der Befestigungsmittel-Durchtrittsöffnung 108 - diametral gegenüberliegenden Randabschnitten 162 an den Anlagebereich 142 des Gehäusedeckels 100 an.

Im Übrigen stimmt die in den Fig. 22 und 23 dargestellte sechste Ausführungsform eines Gehäusedeckels 100 hinsichtlich Aufbau, Funktion und Herstellungsweise mit der in den Fig. 20 und 21 dargestellten fünften Ausführungsform überein, auf deren vorstehende Beschreibung insoweit Bezug genommen wird.

Eine in den Fig. 24 und 25 dargestellte siebte Ausführungsform eines Gehäusedeckels 100 unterscheidet sich von der in den Fig. 1 bis 3 dargestellten ersten Ausführungsform dadurch, dass das Verformungsbegrenzungselement 132 des Gehäusedeckels 100 nicht nur Befestigungsmittel-Durchtrittsöffnungs-Abschnitte 136 umfasst, die sich jeweils längs einer Umfangsrichtung einer der Befestigungsmittel-Durchtrittsöffnungen 108 erstrecken, sondern auch ein oder mehrere Zwischen-Befestigungsmittel-Durchtrittsöffnungs-Abschnitte 164, die sich jeweils längs einer Umfangsrichtung eines zwischen zwei der Befestigungsmittel-Durchtrittsöffnungen 108 liegenden Randabschnitts 166 des Gehäusedeckels 100 erstrecken.

Auch in diesen Zwischen-Befestigungsmittel-Durchtrittsöffnungs-Abschnitten 164 umfasst das Verformungsbegrenzungselement 132 jeweils einen Anlagebereich 142, einen Biegebereich 138 und einen Umlagebereich 140, der flächig, vorzugsweise im Wesentlichen vollflächig, an der Anlagefläche 148 des Anlagebereichs 142 anliegt und vorzugsweise mit dem Anlagebereich 142 verpresst ist.

Ein solcher Zwischen-Befestigungsmittel-Durchtrittsöffnungs-Abschnitt 164 des Verformungsbegrenzungselements 132 dient nicht nur zur Begrenzung der Verformung des Dichtungswulstes 120 bei der Montage des Gehäusedeckels 100 an dem Gehäuse 102, sondern kann auch zum Schutz des Dichtungswulstes 120 gegen äußere Einflüsse dienen, beispielsweise gegen das Eindringen von Verunreinigungen oder aggressiven Medien oder von unter Druck stehenden Medien, beispielsweise von dem Fluid eines Hochdruck-Wasserstrahls, da der Umlagebereich 140 eines solchen Zwischen-Befestigungsmittel-Durchtrittsöffnungs-Abschnitts 164 flächig, vorzugsweise im Wesentlichen vollflächig, an dem Gehäuse 102 anliegt und somit verhindert, dass zwischen dem Gehäusedeckel 100 und dem Gehäuse 102 ein Spalt entsteht, durch den solche Verunreinigungen oder aggressive und/oder unter hohem Druck stehende Medien zu dem Dichtungswulst 120 gelangen könnten.

Außerdem kann der Umlagebereich 140 eines solchen Zwischen-Befestigungsmittel-Durchtrittsöffnungs-Abschnitts 164 eines Verformungsbegrenzungselements 132 einen elektrisch leitfähigen Kontakt zwischen dem Gehäusedeckel 100 und dem Gehäuse 102 gewährleisten, so dass die Einheit aus Gehäusedeckel 100 und Gehäuse 102 einen EMV-Schutz aufweist, der Einwirkungen von elektrischen, magnetischen oder elektromagnetischen Feldern aus dem Außenraum des Gehäuses 102 auf elektrische Vorrichtungen im Innenraum des Gehäuses 102 verhindert.

Im Übrigen stimmt die in den Fig. 24 und 25 dargestellte siebte Ausführungsform eines Gehäusedeckels 100 hinsichtlich Aufbau, Funktion und Herstellungsweise mit der in den Fig. 1 bis 3 dargestellten ersten Ausführungsform überein, auf deren vorstehende Beschreibung insoweit Bezug genommen wird.

Auch bei der siebten Ausführungsform eines Gehäusedeckels können der Anlagebereich 142 und/oder der Umlagebereich 140 in jedem der Zwischen-Befestigungsmittel-Durchtrittsöffnungs-Abschnitte 164 und/oder in jedem der Befestigungsmittel-Durchtrittsöffnungs-Abschnitte 136 des Verformungsbegrenzungselements 132 in derselben Weise planiert werden, wie das vorstehend im Zusammenhang mit der zweiten Ausführungsform, der dritten Ausführungsform oder der vierten Ausführungsform eines Gehäusedeckels 100 beschrieben worden ist.

Eine in den Fig. 26 und 27 dargestellte achte Ausführungsform eines Gehäusedeckels 100 unterscheidet sich von der vorstehend beschriebenen, in den Fig. 24 und 25 dargestellten siebten Ausführungsform dadurch, dass der Umlagebereich 140 eines Zwischen-Befestigungsmittel-Durchtrittsöffnungs-Abschnitts 164 des Verformungsbegrenzungselements 132 nicht einteilig ausgebildet ist, sondern aus mehreren Segmenten 168 zusammengesetzt ist, welche in der Umfangsrichtung des Randabschnitts 166 des Gehäusedeckels 100 aufeinander folgen und vorzugsweise durch die Verpressung mit dem Anlagebereich 142 zusammengeflossen sind.

In der in Fig. 27 dargestellten Gehäusedeckel-Vorform 144 dieser Ausführungsform des Gehäusedeckels 100 ist zwischen jeweils zwei in der Umfangsrichtung des Randabschnitts 166 des Gehäusedeckels 100 aufeinanderfolgenden Segment-Vorformen 170 jeweils eine Lücke 172 angeordnet.

Die Segment-Vorformen 170 und damit die daraus entstehenden Segmente 168 können alle dieselbe Länge aufweisen oder hinsichtlich ihrer Länge - längs der Umfangsrichtung des Randabschnitts 166 des Gehäusedeckels 100 genommen - voneinander abweichen.

Im Übrigen stimmt die in den Fig. 26 und 27 dargestellte achte Ausführungsform eines Gehäusedeckels 100 hinsichtlich Aufbau, Funktion und Herstellungsweise mit der in den Fig. 24 und 25 dargestellten siebten Ausführungsform überein, auf deren vorstehende Beschreibung insoweit Bezug genommen wird.

Insbesondere können auch bei der achten Ausführungsform die Segmente 156 und/oder der Anlagebereich 142 durch einen Planiervorgang in ihrer Höhe gegenüber der Höhe D des Ausgangsmaterials reduziert sein.

Eine in den Fig. 28 und 29 dargestellte neunte Ausführungsform eines Gehäusedeckels 100 unterscheidet sich von der in den Fig. 24 und 25 dargestellten siebten Ausführungsform dadurch, dass im Zwischen-Befestigungsmittel-Durchtrittsöffnungs-Abschnitt 164 des Verformungsbegrenzungselement 132 der Biegebereich 138 nicht um einen Biegewinkel α von 180 aus der parallel zur Dichtungstragefläche 122 verlaufenden Bezugsebene 139 herausgebogen ist, sondern der Biegewinkel α im Wesentlichen 90° beträgt und der Biegebereich 138 an einer Stirnfläche 174 endet, mit welcher der Gehäusedeckel 100 im am Gehäuse 102 montierten Zustand an dem Gehäuse 102 anliegt (siehe Fig. 29).

In diesem Fall entfällt somit der Umlagebereich 140 des Verformungsbegrenzungselements 132.

Der um 90° aus der Bezugsebene 139 herausgebogene Abschnitt des Biegebereichs 138, welcher um die Höhe H über die Dichtungstragefläche 122 des Gehäusedeckels 100 vorsteht, begrenzt bei dieser Ausführungsform des Gehäusedeckels 100 die Verformung des Dichtwulstes 120 bei der Montage des Gehäusedeckels 100 an dem Gehäuse 102.

In einer parallel zur Dichtungstragefläche 122 und senkrecht zum äußeren Rand des Gehäusedeckels 100 verlaufenden Richtung weist diese Ausführungsform eines Verformungsbegrenzungselements 132 nur eine sehr geringe Ausdehnung auf, welche im Wesentlichen der Dicke D des Ausgangsmaterials des Gehäusedeckels 100 entspricht oder nur geringfügig größer ist als die Dicke D. Insbesondere kann vorgesehen sein, dass die Ausdehnung des Verformungsbegrenzungselements 132 parallel zu der Dichtungstragefläche 122 und senkrecht zum Rand des Gehäusedeckels 100 weniger als das Doppelte der Dicke D des Ausgangsmaterials des Gehäusedeckels 100 beziehungsweise der Dicke D das Dichtungstragebereichs 106 des Gehäusedeckels 100 beträgt.

Hierdurch wird in dem ohnehin sehr schmalen Zwischen-Befestigungsmittel-Durchtrittsöffnungs-Bereich 126 des Gehäusedeckels 100 viel Platz gespart, indem der Biegebereich 138 des Verformungsbegrenzungselements 132 nicht über einen Biegewinkel α von 180°, sondern nur um einen Biegewinkel α von 90° gebogen und senkrecht zur Dichtungstragefläche 122 gestellt wird.

Im Übrigen stimmt die in den Fig. 28 und 29 dargestellte neunte Ausführungsform eines Gehäusedeckels 100 hinsichtlich Aufbau, Funktion und Herstellungsweise mit der in den Fig. 24 und 25 dargestellten siebten Ausführungsform des Gehäusedeckels 100 überein, auf deren vorstehende Beschreibung insoweit Bezug genommen wird.

Eine in Fig. 30 dargestellte zehnte Ausführungsform eines Gehäusedeckels 100 unterscheidet sich von der in den Fig. 28 und 29 dargestellten neunten Ausführungsform dadurch, dass das Verformungsbegrenzungselement 132 nicht nur in dem Zwischen-Befestigungsmittel-Durchtrittsöffnungs-Abschnitt 164, sondern ergänzend oder alternativ hierzu auch in dem Befestigungsmittel-Durchtrittsöffnungs-Abschnitt 136 des Verformungsbegrenzungselements 132 durch einen Biegebereich 138 mit einem Biegewinkel von im Wesentlichen 90° gebildet ist. Insbesondere kann das Verformungsbegrenzungselement 132 bei dieser Ausführungsform einen zusätzlichen Biegebereich 138' aufweisen, welcher die Befestigungsmittel-Durchtrittsöffnung 108 (mit dem Durchmesser d; siehe Fig. 30) berandet und mit seiner Stirnfläche 174 im am Gehäuse 102 montierten Zustand des Gehäusedeckels 100 an dem Gehäuse 102 anliegt.

Auch dieser Biegebereich 138' weist einen Biegewinkel von im Wesentlichen 90° auf.

Auch an diesen Biegebereich 138' schließt sich kein auf einen Anlagebereich 142 des Gehäusedeckels 100 umgelegter Umlagebereich 140 an.

Im Übrigen stimmt die in Fig. 30 dargestellte zehnte Ausführungsform eines Gehäusedeckels 100 hinsichtlich Aufbau, Funktion und Herstellungsweise mit der in den Fig. 28 und 29 dargestellten neunten Ausführungsform überein, auf deren vorstehende Beschreibung insoweit Bezug genommen wird.

Eine in Fig. 31 dargestellte elfte Ausführungsform eines Gehäusedeckels 100 unterscheidet sich von der in den Fig. 28 und 29 dargestellten neunten Ausführungsform dadurch, dass der Gehäusedeckel 100 eine oder mehrere Ablauföffnungen 176 umfasst, welche jeweils zwischen einem Endbereich eines Zwischen-Befestigungsmittel-Durchtrittsöffnungs-Abschnitts 164 des Verformungsbegrenzungselements 132 und einem Befestigungsmittel-Durchtrittsöffnungs-Abschnitt 136 des Verformungsbegrenzungselements 132 angeordnet sind.

Diese Ablauföffnungen 176 stellen jeweils eine Fluidverbindung von dem Zwischenbereich zwischen dem Dichtungswulst 120 und dem Zwischen-Befestigungsmittel-Durchtrittsöffnungs-Abschnitt 164 des Verformungsbegrenzungselements 132 in den Außenraum des Gehäusedeckels 100 dar, über welche Feuchtigkeit oder Flüssigkeit, welche in diesem Zwischenbereich entsteht und/oder sich ansammelt, in den Außenraum des Gehäusedeckels 100 ablaufen kann, wodurch eine korrosive Schädigung des Gehäusedeckels in diesem Zwischenbereich verhindert wird.

Bei dieser Ausführungsform weist jede der Ablauföffnungen 176 somit die Form einer Lücke oder eines Spaltes zwischen einem Endbereich eines Zwischen-Befestigungsmittel-Durchtrittsöffnungs-Abschnitts 164 des Verformungsbegrenzungselements 132 und einem Befestigungsmittel-Durchtrittsöffnungs-Abschnitt 136 des Verformungsbegrenzungselements 132 auf.

Im Übrigen stimmt die in Fig. 31 dargestellte elfte Ausführungsform eines Gehäusedeckels 100 hinsichtlich Aufbau, Funktion und Herstellungsweise mit der in den Fig. 28 und 29 dargestellten neunten Ausführungsform überein, auf deren vorstehende Beschreibung insoweit Bezug genommen wird.

Bei alternativen Ausgestaltungen der elften Ausführungsform eines Gehäusedeckels 100 kann vorgesehen sein, dass die Zwischen-Befestigungsmittel-Durchtrittsöffnungs-Abschnitte 164 des Verformungsbegrenzungselements 132 so ausgebildet sind, wie bei der in Fig. 24 und 25 dargestellten siebten Ausführungsform eines Gehäusedeckels 100.

In diesem Fall umfasst das Verformungsbegrenzungselement in den Zwischen-Befestigungsmittel-Durchtrittsöffnungs-Abschnitten 164 also jeweils einen Anlagebereich 142, einen Biegebereich 138 und einen Umlagebereich 140, der flächig, vorzugsweise im Wesentlichen vollflächig, an der Anlagefläche 148 des Anlagebereichs 142 anliegt und vorzugsweise mit dem Anlagebereich 142 verpresst ist.

Bei einer weiteren alternativen Ausgestaltung der elften Ausführungsform eines Gehäusedeckels 100 können die Zwischen-Befestigungsmittel-Durchtrittsöffnungs-Abschnitte 164 des Verformungsbegrenzungselements 132 so ausgebildet sein wie bei der in den Fig. 26 und 27 dargestellten achten Ausführungsform eines Gehäusedeckels 100.

In diesem Fall ist der Umlagebereich 140 eines Zwischen-Befestigungsmittel-Durchtrittsöffnungs-Abschnitts 164 des Verformungsbegrenzungselements 132 nicht einteilig ausgebildet, sondern aus mehreren Segmenten 168 zusammengesetzt, welche in der Umfangsrichtung des Randabschnitts 166 des Gehäusedeckels 100 aufeinander folgen und vorzugsweise durch die Verpressung mit dem Anlagebereich 142 zusammengeflossen sind.

## Patentansprüche

1. Gehäusedeckel zum Festlegen an einem Gehäuse (102),
wobei der Gehäusedeckel (100) mit mehreren Befestigungsmittel-Durchtrittsöffnungen (108) und mit einem Dichtungswulst (120), der ein elastomeres Material umfasst, versehen ist und
wobei der Dichtungswulst (120) an einer Dichtungstragefläche (122) des Gehäusedeckels (100) angeordnet ist,
wobei der Gehäusedeckel (100) mindestens ein Verformungsbegrenzungselement (132) umfasst, welches über die Dichtungstragefläche (122) in derselben Richtung vorsteht wie der Dichtungswulst (120) und eine Verformung des Dichtungswulstes (120) im montierten Zustand des Gehäusedeckels (100) begrenzt, und
wobei das Verformungsbegrenzungselement (132) einen Biegebereich (138; 138') umfasst, in welchem das Material des Verformungsbegrenzungselements (132) um einen Biegewinkel (α) von mindestens 30° aus einer im Wesentlichen parallel zu der Dichtungstragefläche (122) verlaufenden Bezugsebene (139) herausgebogen ist,
**dadurch gekennzeichnet,**
**dass** das Verformungsbegrenzungselement (132) mindestens einen Befestigungsmittel-Durchtrittsöffnungs-Abschnitt (136) umfasst, der sich längs einer Umfangsrichtung einer der Befestigungsmittel-Durchtrittsöffnungen (108) über einen Umfangswinkel (β) um die betreffende Befestigungsmittel-Durchtrittsöffnung (108) erstreckt,
und/oder
**dass** das Verformungsbegrenzungselement (132) mindestens einen Zwischen-Befestigungsmittel-Durchtrittsöffnungs-Abschnitt (164) umfasst, der sich längs einer Umfangsrichtung eines zwischen zwei der Befestigungsmittel-Durchtrittsöffnungen (108) liegenden Randabschnitts (166) des Gehäusedeckels (100) erstreckt,
wobei der mindestens eine Befestigungsmittel-Durchtrittsöffnungs-Abschnitt (136) und/oder der mindestens eine Zwischen-Befestigungsmittel-Durchtrittsöffnungs-Abschnitt (164) des Verformungsbegrenzungselements (132) mehrere Segmente (156; 168) umfasst, zwischen denen in einem Ausgangszustand des Gehäusedeckels (100) vor dem Erzeugen des Biegebereichs (138) mindestens eine Lücke (160; 172) angeordnet ist.

2. Gehäusedeckel nach Anspruch 1, **dadurch gekennzeichnet, dass** der Biegewinkel (α) im Wesentlichen 90° beträgt.

3. Gehäusedeckel nach einem der Ansprüche 1 oder 2, **dadurch gekennzeichnet, dass** der Biegebereich (138) an einer Stirnfläche (174; 174') endet, mit welcher der Gehäusedeckel (100) an das Gehäuse (102) anlegbar ist.

4. Gehäusedeckel nach Anspruch 1, **dadurch gekennzeichnet, dass** der Biegewinkel (α) mehr als 160° beträgt.

5. Gehäusedeckel nach einem der Ansprüche 1 oder 4, **dadurch gekennzeichnet, dass** das Verformungsbegrenzungselement (132) einen Umlagebereich (140) umfasst, welcher über den Biegebereich (138) und einen Anlagebereich (142) mit einem Dichtungstragebereich (106) des Gehäusedeckels (100), an welchem der Dichtungswulst (120) angeordnet ist, verbunden ist, wobei der Umlagebereich (140) an dem Anlagebereich (142) auf derselben Seite des Gehäusedeckels (100) anliegt, auf welcher der Dichtungswulst (120) an dem Dichtungstragebereich (106) angeordnet ist.

6. Gehäusedeckel nach Anspruch 5, **dadurch gekennzeichnet, dass** die mittlere Dicke (D; D') des Umlagebereichs (140) im Wesentlichen gleich groß ist wie die mittlere Dicke (D; D') des Anlagebereichs (142).

7. Gehäusedeckel nach Anspruch 5, **dadurch gekennzeichnet, dass** die mittlere Dicke (D') des Umlagebereichs (140) kleiner ist als die mittlere Dicke (D) des Anlagebereichs (142).

8. Gehäusedeckel nach einem der Ansprüche 5 bis 7, **dadurch gekennzeichnet, dass** die Dicke des Umlagebereichs (140) mit wachsendem Abstand von dem Biegebereich (138) variiert.

9. Gehäusedeckel nach einem der Ansprüche 5 bis 8, **dadurch gekennzeichnet, dass** die Dicke des Anlagebereichs (142) mit wachsendem Abstand von dem Biegebereich (138) variiert.

10. Gehäusedeckel nach einem der Ansprüche 5 bis 9, **dadurch gekennzeichnet, dass** die Summe (D_{G}) aus der lokalen Dicke (D_{U}) des Umlagebereichs (140) und der lokalen Dicke (D_{A}) des Anlagebereichs (142) im Wesentlichen unabhängig vom Abstand von dem Biegebereich (138) ist.

11. Gehäusedeckel nach einem der Ansprüche 5 bis 10, **dadurch gekennzeichnet, dass** die Dicke (D'; D_{U}) des Umlagebereichs (140) und/oder die Dicke (D'; D_{A}) des Anlagebereichs (142) zumindest abschnittsweise kleiner ist als die Dicke (D) des Dichtungstragebereichs (106).

12. Gehäusedeckel nach einem der Ansprüche 1 bis 11, **dadurch gekennzeichnet, dass** mindestens einer der Zwischen-Befestigungsmittel-Durchtrittsöffnungs-Abschnitte (164) des Verformungsbegrenzungselements (132) mindestens eine Ablauföffnung (176) aufweist und/oder an mindestens einer Ablauföffnung (176) endet.

13. Gehäusedeckel nach Anspruch 12, **dadurch gekennzeichnet, dass** mindestens eine Ablauföffnung (176) von einem Zwischen-Befestigungsmittel-Durchtrittsöffnungs-Abschnitt (164) und von einem Befestigungsmittel-Durchtrittsöffnungs-Abschnitt (136) des Verformungsbegrenzungselements (132) begrenzt wird.

14. Gehäusedeckel nach einem der Ansprüche 1 bis 13, **dadurch gekennzeichnet, dass** im betriebsbereiten Zustand des Gehäusedeckels (100) die Segmente (156; 168) miteinander verpresst sind.

## Claims

1. Housing cover for fixing to a housing (102),
wherein the housing cover (100) is provided with a plurality of fastening means through-openings (108) and with a sealing bead (120) that comprises an elastomeric material and
wherein the sealing bead (120) is arranged on a seal support face (122) of the housing cover (100),
wherein the housing cover (100) comprises at least one deformation limiting element (132), which projects over the seal support face (122) in the same direction as the sealing bead (120) and limits a deformation of the sealing bead (120) in the assembled state of the housing cover (100), and
wherein the deformation limiting element (132) comprises a bending region (138; 138') in which the material of the deformation limiting element (132) is bent out of a reference plane (139) extending substantially in parallel to the seal support face (122) by a bend angle (α) of at least 30°,
**characterized in that**
the deformation limiting element (132) comprises at least one fastening means through-opening portion (136), which extends along a circumferential direction of one of the fastening means through-openings (108) over a circumferential angle (β) around the respective fastening means through-opening (108),
and/or
**in that** the deformation limiting element (132) comprises at least one intermediate fastening means through-opening portion (164), which extends along a peripheral direction of a rim portion (166) of the housing cover (100) located between two of the fastening means through-openings (108),
wherein the at least one fastening means through-opening portion (136) and/or the at least one intermediate fastening means through-opening portion (164) of the deformation limiting element (132) comprises a plurality of segments (156; 168), between which at least one gap (160; 172) is arranged in an initial state of the housing cover (100) before producing the bending region (138).

2. Housing cover in accordance with Claim 1, **characterized in that** the bend angle (α) is substantially 90°.

3. Housing cover in accordance with either of Claims 1 or 2, **characterized in that** the bending region (138) ends on an end face (174; 174') with which the housing cover (100) can be placed against the housing (102).

4. Housing cover in accordance with Claim 1, **characterized in that** the bend angle (α) is more than 160°.

5. Housing cover in accordance with any one of Claims 1 to 4, **characterized in that** the deformation limiting element (132) comprises a folding over region (140), which is connected by way of the bending region (138) and an abutment region (142) to a seal support region (106) of the housing cover (100) on which the sealing bead (120) is arranged, wherein the folding over region (140) abuts against the abutment region (142) on the same side of the housing cover (100) on which the sealing bead (120) is arranged on the seal support region (106).

6. Housing cover in accordance with Claim 5, **characterized in that** the average thickness (D; D') of the folding over region (140) is substantially equal to the average thickness (D; D') of the abutment region (142).

7. Housing cover in accordance with Claim 5, **characterized in that** the average thickness (D') of the folding over region (140) is smaller than the average thickness (D) of the abutment region (142).

8. Housing cover in accordance with any one of Claims 5 to 7, **characterized in that** the thickness of the folding over region (140) varies with increasing distance from the bending region (138).

9. Housing cover in accordance with any one of Claims 5 to 8, **characterized in that** the thickness of the abutment region (142) varies with increasing distance from the bending region (138).

10. Housing cover in accordance with any one of Claims 5 to 9, **characterized in that** the sum (D_{G}) of the local thickness (D_{U}) of the folding over region (140) and the local thickness (D_{A}) of the abutment region (142) is substantially independent of the distance from the bending region (138).

11. Housing cover in accordance with any one of Claims 5 to 10, **characterized in that** the thickness (D'; D_{U}) of the folding over region (140) and/or the thickness (D'; D_{A}) of the abutment region (142) is smaller than the thickness (D) of the seal support region (106) at least in sections.

12. Housing cover in accordance with any one of Claims 1 to 11, **characterized in that** at least one of the intermediate fastening means through-opening portions (164) of the deformation limiting element (132) has at least one outlet opening (176) and/or ends with at least one outlet opening (176).

13. Housing cover in accordance with Claim 12, **characterized in that** at least one outlet opening (176) is delimited by an intermediate fastening means through-opening portion (164) and by a fastening means through-opening portion (136) of the deformation limiting element (132).

14. Housing cover in accordance with any one of Claims 1 to 13, **characterized in that** the segments (156; 168) are pressed together in the operational state of the housing cover (100).

## Revendications

1. Couvercle de boîtier destiné à être fixé sur un boîtier (102),
dans lequel le couvercle (100) de boîtier est pourvu de plusieurs ouvertures de passage (108) de moyen de fixation et d'un bourrelet d'étanchéité (120), qui comprend un matériau élastomère,
dans lequel le bourrelet d'étanchéité (120) est disposé sur une surface de support d'étanchéité (122) du couvercle (100) de boîtier,
dans lequel le couvercle (100) de boîtier comprend au moins un élément de limitation de déformation (132), qui fait saillie au-delà de la surface de support d'étanchéité (122) dans la même direction que le bourrelet d'étanchéité (120) et qui limite une déformation du bourrelet d'étanchéité (120) dans l'état monté du couvercle (100) de boîtier, et
dans lequel l'élément de limitation de déformation (132) comprend une zone de flexion (138 ; 138'), dans laquelle le matériau de l'élément de limitation de déformation (132) est courbé vers l'extérieur d'un angle de flexion (α) d'au moins 30° à partir d'un plan de référence (139) s'étendant sensiblement parallèlement à la surface de support d'étanchéité (122),
**caractérisé en ce**
**que** l'élément de limitation de déformation (132) comprend au moins une section (136) d'ouverture de passage de moyen de fixation, qui s'étend le long d'une direction périphérique d'une des ouvertures de passage (108) de moyen de fixation sur un angle périphérique (β) autour de l'ouverture de passage (108) de moyen de fixation concernée, et/ou
**que** l'élément de limitation de déformation (132) comprend au moins une section intermédiaire (164) d'ouverture de passage de moyen de fixation, qui s'étend le long d'une direction périphérique d'une section de bord (166) du couvercle (100) de boîtier située entre deux des ouvertures de passage (108) de moyen de fixation,
dans lequel l'au moins une section (136) d'ouverture de passage de moyen de fixation et/ou l'au moins une section intermédiaire (164) d'ouverture de passage de moyen de fixation de l'élément de limitation de déformation (132) comprend plusieurs segments (156 ; 168) entre lesquels au moins un espace (160 ; 172) est disposé dans un état initial du couvercle (100) de boîtier avant la production de la zone de flexion (138).

2. Couvercle de boîtier selon la revendication 1, **caractérisé en ce que** l'angle de flexion (α) est sensiblement de 90°.

3. Couvercle de boîtier selon l'une quelconque des revendications 1 ou 2, **caractérisé en ce que** la zone de flexion (138) se termine sur une surface frontale (174 ; 174') avec laquelle le couvercle (100) de boîtier peut être appliqué sur le boîtier (102).

4. Couvercle de boîtier selon la revendication 1, **caractérisé en ce que** l'angle de flexion (α) est supérieur à 160°.

5. Couvercle de boîtier selon l'une quelconque des revendications 1 ou 4, **caractérisé en ce que** l'élément de limitation de déformation (132) comprend une zone de rabattement (140) qui est reliée par l'intermédiaire de la zone de flexion (138) et d'une zone d'appui (142) à une zone de support d'étanchéité (106) du couvercle (100) de boîtier, sur laquelle le bourrelet d'étanchéité (120) est disposé, dans lequel la zone de retournement (140) repose sur la zone d'appui (142) sur le même côté du couvercle (100) de boîtier, sur lequel le bourrelet d'étanchéité (120) est disposé sur la zone de support d'étanchéité (106).

6. Couvercle de boîtier selon la revendication 5, **caractérisé en ce que** l'épaisseur moyenne (D ; D') de la zone de rabattement (140) est sensiblement égale à l'épaisseur moyenne (D ; D') de la zone d'appui (142).

7. Couvercle de boîtier selon la revendication 5, **caractérisé en ce que** l'épaisseur moyenne (D') de la zone de rabattement (140) est inférieure à l'épaisseur moyenne (D) de la zone d'appui (142).

8. Couvercle de boîtier selon l'une quelconque des revendications 5 à 7, **caractérisé en ce que** l'épaisseur de la zone de rabattement (140) varie au fur et à mesure qu'une distance par rapport à la zone de flexion (138) augmente.

9. Couvercle de boîtier selon l'une quelconque des revendications 5 à 8, **caractérisé en ce que** l'épaisseur de la zone d'appui (142) varie au fur et à mesure qu'une distance par rapport à la zone de flexion (138) augmente.

10. Couvercle de boîtier selon l'une quelconque des revendications 5 à 9, **caractérisé en ce que** la somme (D_{G}) de l'épaisseur locale (D_{U}) de la zone de rabattement (140) et de l'épaisseur locale (D_{A}) de la zone d'appui (142) est sensiblement indépendante de la distance par rapport à la zone de flexion (138).

11. Couvercle de boîtier selon l'une quelconque des revendications 5 à 10, **caractérisé en ce que** l'épaisseur (D' ; D_{U}) de la zone de rabattement (140) et/ou l'épaisseur (D' ; D_{A}) de la zone d'appui (142) sont au moins par endroits inférieures à l'épaisseur (D) de la zone de support d'étanchéité (106).

12. Couvercle de boîtier selon l'une quelconque des revendications 1 à 11, **caractérisé en ce qu'**au moins une des sections intermédiaires (164) d'ouverture de passage de moyen de fixation de l'élément de limitation de déformation (132) présente au moins une ouverture de sortie (176) et/ou se termine par au moins une ouverture de sortie (176).

13. Couvercle de boîtier selon la revendication 12, **caractérisé en ce qu'**au moins une ouverture de sortie (176) est délimitée par une section intermédiaire (164) d'ouverture de passage de moyen de fixation et par une section (136) d'ouverture de passage de moyen de fixation de l'élément de limitation de déformation (132).

14. Couvercle de boîtier selon l'une quelconque des revendications 1 à 13, **caractérisé en ce que** les segments (156 ; 168) sont comprimés les uns aux autres dans l'état opérationnel du couvercle (100) de boîtier.
